# EUROPEAN PATENT APPLICATION

(11) **EP 4 418 833 A1**
(43) Date of publication of application: **21.08.2024**
(21) Application number: 24157798.0
(22) Date of filing: 15.02.2024
(51) Int. Cl.: H10K 50/12, H10K 50/18, H10K 85/60

(54) **ORGANIC LIGHT-EMITTING ELEMENT**

(30) Priority: 15.02.2023 JP 2023021676; 28.11.2023 JP 2023200923
(71) Applicant: CANON KABUSHIKI KAISHA, Tokyo 146-8501 (JP)
(72) Inventor: NISHIDE, Yosuke, Tokyo, 146-8501 (JP); TAKAYA, Itaru, Tokyo, 146-8501 (JP); YAMADA, Naoki, Tokyo, 146-8501 (JP)
(74) Representative: TBK

(57) **Abstract**

An organic light-emitting element including: an anode (21); a cathode (23); and an organic compound layer (4, 22) between the anode and the cathode, wherein the organic compound layer includes a light-emitting layer and an adjacent layer (44) in contact with a cathode side of the light-emitting layer, the light-emitting layer contains a first organic compound and a light-emitting material, the adjacent layer contains a second organic compound, the first organic compound is a hydrocarbon compound with a hydrocarbon fused-ring skeleton, and the second organic compound is a hydrocarbon compound with a hydrocarbon fused-ring skeleton and at least one alkyl group.

## Description

### BACKGROUND OF THE INVENTION

### Field of the Invention

The present disclosure relates to an organic light-emitting element.

### Description of the Related Art

An organic light-emitting element has a layered structure having a basic structure of anode/light-emitting layer/cathode, and emits light by recombination of a hole from the anode and an electron from the cathode in the light-emitting layer. For the purpose of improving light emission efficiency and durability, a multilayer structure of anode/hole injection layer/hole transport layer/electron-blocking layer/light-emitting layer/hole-blocking layer/electron transport layer/electron injection layer/cathode may be used. The hole-blocking layer is used in contact with the cathode side of the light-emitting layer for the purpose of efficiently supplying an electron injected from the cathode to the light-emitting layer and preventing a decrease in light emission efficiency due to leakage of a hole from the light-emitting layer to the cathode side.

A layer in contact with the cathode side of the light-emitting layer (hereinafter also referred to as an "adjacent layer") functions as a hole-blocking layer, and therefore a compound with a HOMO level lower than the HOMO level of a light-emitting layer host material is used. Thus, a compound with an electron-withdrawing skeleton or substituent is used for the adjacent layer. For the adjacent layer, a compound with high electron mobility is used to efficiently supply electrons to the light-emitting layer. Thus, a compound having a skeleton or a substituent with high planarity is used for the adjacent layer.

Japanese Patent Laid-Open No. 2016-58497 (PTL 1) discloses a constitution of an organic EL element using, in a hole-blocking layer, a material containing chrysene with a benzimidazole substituent in the molecular structure.

In the selection of the adjacent layer, however, both a low drive voltage and high operational durability should be achieved.

### SUMMARY OF THE INVENTION

In view of the above circumstances, the present disclosure provides an organic light-emitting element that achieves both low-voltage driving and high operational durability.

The present disclosure in its first aspect provides an organic light-emitting element as specified in items 1 to 16.

The present disclosure in its second aspect provides a display apparatus as specified in item 17.

The present disclosure in its third aspect provides an image display apparatus as specified in item 18.

The present disclosure in its fourth aspect provides a photoelectric conversion apparatus as specified in item 19.

The present disclosure in its fifth aspect provides electronic equipment as specified in item 20.

The present disclosure in its sixth aspect provides a lighting apparatus as specified in item 21.

The present disclosure in its seventh aspect provides a moving body as specified in item 22.

The present disclosure in its eighth aspect provides an image-forming apparatus as specified in item 23.

Further features of the present disclosure will become apparent from the following description of exemplary embodiments with reference to the attached drawings.

### BRIEF DESCRIPTION OF THE DRAWINGS

Fig. 1A is a schematic cross-sectional view of an example of a pixel of a display apparatus according to an embodiment of the present disclosure.
Fig. 1B is a schematic cross-sectional view of an example of a display apparatus including an organic light-emitting element according to an embodiment of the present disclosure.
Fig. 2 is a schematic view of an example of a display apparatus according to an embodiment of the present disclosure.
Fig. 3A is a schematic view of an example of an imaging apparatus according to an embodiment of the present disclosure.
Fig. 3B is a schematic view of an example of electronic equipment according to an embodiment of the present disclosure.
Fig. 4Ais a schematic view of an example of a display apparatus according to an embodiment of the present disclosure.
Fig. 4B is a schematic view of an example of a foldable display apparatus.
Fig. 5A is a schematic view of an example of a lighting apparatus according to an embodiment of the present disclosure.
Fig. 5B is a schematic view of an example of a moving body with a vehicle lamp according to an embodiment of the present disclosure.
Fig. 6Ais a schematic view of an example of a wearable device according to an embodiment of the present disclosure.
Fig. 6B is a schematic view of another example of a wearable device according to an embodiment of the present disclosure.
Fig. 7A is a schematic view of an example of an image-forming apparatus according to an embodiment of the present disclosure.
Fig. 7B is a schematic view of an example of an exposure light source for an image-forming apparatus according to an embodiment of the present disclosure.
Fig. 7C is a schematic view of an example of an exposure light source for an image-forming apparatus according to an embodiment of the present disclosure.
Fig. 8 is a schematic view of one form of a light-emitting device according to the present embodiment.
Fig. 9A is a schematic perspective view of a head substrate.
Fig. 9B is a view of an arrangement of a plurality of light-emitting elements provided on the head substrate.
Fig. 9C is a partial enlarged view of Fig. 9B.

### DESCRIPTION OF THE EMBODIMENTS

An organic light-emitting element according to the present disclosure includes an anode, a cathode, and an organic compound layer between the anode and the cathode. The organic compound layer includes a light-emitting layer and an adjacent layer in contact with a cathode side of the light-emitting layer. An organic light-emitting element according to the present disclosure may be an organic EL (electroluminescence) element.

The light-emitting layer contains a first organic compound and a light-emitting material. The first organic compound may be a host material, and the light-emitting material may be a light-emitting dopant material.

A host is a compound with the highest mass ratio among the compounds constituting a light-emitting layer. A light-emitting dopant (guest) is a compound that has a lower mass ratio than the host among the compounds constituting a light-emitting layer and that is a principal light-emitting compound. The concentration of a light-emitting dopant (light-emitting material) is preferably 0.01% by mass or more and 20% by mass or less, more preferably 0.05% by mass or more and 5.0% by mass or less, with respect to the entire light-emitting layer.

The adjacent layer contains a second organic compound. The second organic compound may be a compound different from the first organic compound. The concentration of the second organic compound is preferably 50% by weight or more, more preferably 70% by weight or more, still more preferably 90% by weight or more, with respect to the entire adjacent layer.

In the organic light-emitting element according to the present embodiment, the first organic compound is a hydrocarbon compound with a hydrocarbon fused-ring skeleton and has the following constitution. Thus, the organic light-emitting element achieves both low-voltage driving and high operational durability. (1) The second organic compound is a hydrocarbon compound with a hydrocarbon fused-ring skeleton and at least one alkyl group.

In general, an adjacent layer material has a parent skeleton with high planarity and an electron-withdrawing substituent to have high electron transport properties and a low HOMO level (far from the vacuum level) for a lower voltage and higher efficiency. However, a parent skeleton with high planarity tends to have high stackability due to a reduced thickness, tends to have non-smooth bonding with a light-emitting layer formed of a different material, and tends to have accumulated electric charges at the interface between the layers. Thus, degradation of a compound may be accelerated due to quenching of excitons and electric charges or the like, and element durability may deteriorate. Furthermore, an electron-withdrawing skeleton containing a heteroatom is unstable with respect to holes, degradation of an adjacent layer material is therefore accelerated as electric charges are accumulated at an adjacent layer interface, and the element durability is deteriorated.

In the present disclosure, the second organic compound in the adjacent layer has a molecular structure with an alkyl group in a hydrocarbon fused-ring skeleton without a heteroatom. This can increase the compatibility between the first organic compound contained in the light-emitting layer and the second organic compound contained in the adjacent layer, improve the bonding at the interface between the light-emitting layer and the adjacent layer, and smooth charge transfer. These are effects due to an interaction between a π electron of the hydrocarbon fused-ring skeleton and a hydrogen of the alkyl group. The term "hydrocarbon fused-ring skeleton", as used herein, refers to a skeleton of a fused ring composed only of carbon and hydrogen.

The characteristics of the present embodiment is described below with reference to Table 1. As described in detail in Exemplary Embodiments, the element voltage and the element durability (luminance decay rate) shown in Table 1 are ratios based on the values obtained for an organic light-emitting element of Comparison 2, which are set to 1.0.

Comparison 1 shows the results of element characteristics in the case where the second organic compound is a compound with a molecular structure including a fused-ring skeleton containing a heteroatom and with high planarity (Comparative Compound 2 described later). On the other hand, in the present disclosures 1 and 2, although the first organic compound is the same compound as in Comparison 1 (Exemplary Compound H8 described later), the second organic compound is a compound with a molecular structure having an alkyl group in a hydrocarbon fused-ring skeleton without a heteroatom (Exemplary Compounds E6 and E26 described later). In the present disclosures 1 and 2, the second organic compound is a compound with a molecular structure having an alkyl group in a hydrocarbon fused-ring skeleton without a heteroatom, and the operational durability is therefore improved as compared with Comparison 1.

On the other hand, in Comparison 2, although the first organic compound is the same compound as in the present disclosures 1 and 2 and Comparison 1 (Exemplary Compound H8), the second organic compound is a compound with a hydrocarbon fused-ring skeleton without a heteroatom (Comparative Compound 1 described later). In Comparison 2, the second organic compound is a compound with a hydrocarbon fused-ring skeleton without a heteroatom, and the operational durability is therefore improved as compared with Comparison 1 in which the second organic compound is a compound containing a heteroatom. However, Comparison 2 is inferior in operational durability to the present disclosures 1 and 2 in which the second organic compound is a compound with an alkyl group.

In the present disclosure 3, the first organic compound is a compound without an alkyl group (Exemplary Compound H6 described later), and the second organic compound is a compound with an alkyl group (Exemplary Compound E6 described later). As in the present disclosure 3, when the first organic compound is a compound without an alkyl group and the second organic compound is a compound with an alkyl group, the operational durability is improved as compared with Comparison 2. Thus, the second organic compound with an alkyl group is particularly effective for improving the operational durability.

**Table 1**

| | First organic compound | Second organic compound | Voltage | Durability |
|---|---|---|---|---|
| Present disclosure 1 | 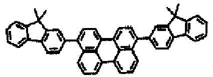 | 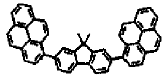 | 0.9 | 1.3 |
| Present disclosure 2 | 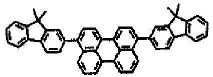 | 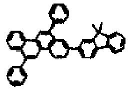 | 1.0 | 1.3 |
| Comparison 1 | 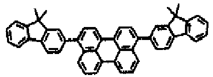 | 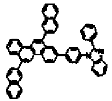 | 1.0 | 0.8 |
| Comparison 2 | 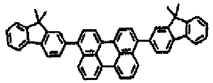 | 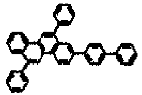 | 1.0 | 1.0 |
| Present disclosure 3 | 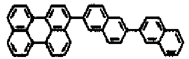 | 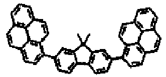 | 0.9 | 1.2 |

An organic light-emitting element according to the present disclosure can also have the following features. (2) The maximum number of fused rings in the hydrocarbon fused-ring skeleton of the second organic compound is smaller than the maximum number of fused rings in the hydrocarbon fused-ring skeleton of the first organic compound.

The adjacent layer can have not only a function of blocking holes but also a function of confining excitons recombined in the light-emitting layer in the light-emitting layer. Thus, the band gap of the second organic compound in the adjacent layer can be larger than the band gap of the first organic compound in the light-emitting layer. The band gap of the hydrocarbon fused-ring skeleton decreases as the number of fused rings increases. Thus, to confine excitons in the light-emitting layer and increase the light emission efficiency, the maximum number of fused rings in the hydrocarbon fused-ring skeleton of the second organic compound can be smaller than the maximum number of fused rings in the hydrocarbon fused-ring skeleton of the first organic compound. The term "maximum number of fused rings", as used herein, refers to the number of fused rings in the hydrocarbon fused-ring skeleton with the largest number of fused rings among the hydrocarbon fused-ring skeletons of the compound.

For example, among the hydrocarbon fused-ring skeletons of the first organic compound, the number of fused rings in the hydrocarbon fused-ring skeleton with the largest number of fused rings may be 4 or more and 8 or less and may be 5 or more and 7 or less. For example, among the hydrocarbon fused-ring skeletons of the second organic compound, the number of fused rings in the hydrocarbon fused-ring skeleton with the largest number of fused rings may be 3 or more and 6 or less and may be 3 or more and 5 or less. Within such a range, the maximum number of fused rings in the hydrocarbon fused-ring skeleton of the second organic compound can be smaller than the maximum number of fused rings in the hydrocarbon fused-ring skeleton of the first organic compound.

Specific examples of the hydrocarbon fused-ring skeleton of the first organic compound include, but are not limited to, the following. heptacyclic 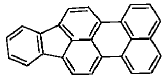 octacyclic 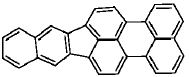 hexacyclic 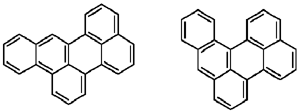 pentacyclic 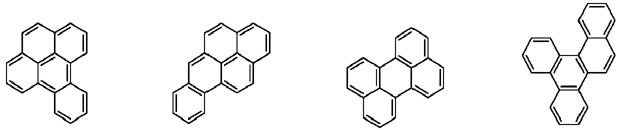 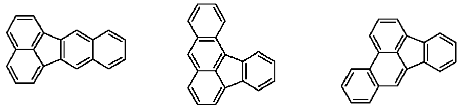 tetracyclic 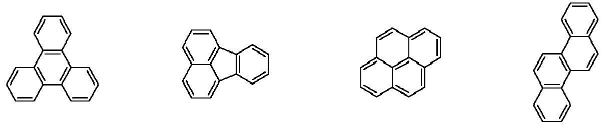 tricyclic

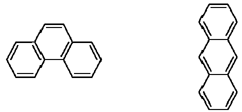

Specific examples of the hydrocarbon fused-ring skeleton of the second organic compound include, but are not limited to, the following.
**pentacyclic** 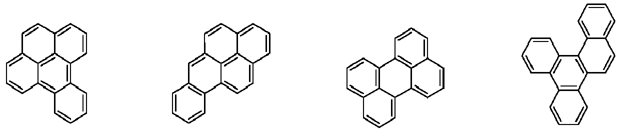 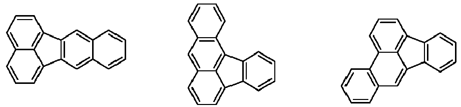 tetracyclic 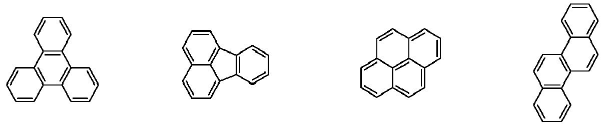 tricyclic

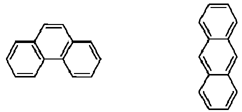

(3) The first organic compound has at least one alkyl group.

As described above, the second organic compound as the adjacent layer material has a molecular structure with an alkyl group in the hydrocarbon fused-ring skeleton, and a π electron of the hydrocarbon fused-ring skeleton interacts with a hydrogen of the alkyl group. This can increase compatibility, improve the bonding at the interface between the light-emitting layer and the adjacent layer, and smooth charge transfer. Thus, the first organic compound can also have an alkyl group. Thus, both the first organic compound and the second organic compound can have an alkyl group.

As shown in Table 1, the second organic compounds of the present disclosure 1 and the present disclosure 3 are the same (Exemplary Compound E6). However, the present disclosure 1 in which the first organic compound is a compound with an alkyl group (Exemplary Compound H8) is further improved in operational durability as compared with the present disclosure 3 in which the first organic compound is a compound without an alkyl group (Exemplary Compound H6). (4) The difference between the maximum number of fused rings in the hydrocarbon fused-ring skeleton of the first organic compound and the maximum number of fused rings in the hydrocarbon fused-ring skeleton of the light-emitting material is larger than the difference between the maximum number of fused rings in the hydrocarbon fused-ring skeleton of the first organic compound and the maximum number of fused rings in the hydrocarbon fused-ring skeleton of the second organic compound.

As described above, the light-emitting layer and the adjacent layer can have high compatibility and good bonding at the interface between the light-emitting layer and the adjacent layer, so that charge transfer is smooth. As another means to enhance compatibility, it has been found that a closer similarity in the number of fused rings in the hydrocarbon fused-ring skeleton with the maximum number of fused rings improves compatibility. Thus, to enhance the compatibility with the second organic compound, the number of fused rings in the hydrocarbon fused-ring skeleton with the maximum number of fused rings of the first organic compound can be closer to that of the second organic compound than that of the light-emitting material.

For example, among the hydrocarbon fused-ring skeletons of the first organic compound, the number of fused rings in the hydrocarbon fused-ring skeleton with the largest number of fused rings may be 4 or more and 8 or less and may be 5 or more and 7 or less. For example, among the hydrocarbon fused-ring skeletons of the second organic compound, the number of fused rings in the hydrocarbon fused-ring skeleton with the largest number of fused rings may be 3 or more and 6 or less and may be 3 or more and 5 or less. Among the hydrocarbon fused-ring skeletons of the light-emitting material, the number of fused rings in the hydrocarbon fused-ring skeleton with the largest number of fused rings may be 8 or more and 14 or less and may be 10 or more and 14 or less.

The difference between the maximum number of fused rings in the hydrocarbon fused-ring skeleton of the first organic compound and the maximum number of fused rings in the hydrocarbon fused-ring skeleton of the second organic compound may be 0 or more and 2 or less and may be 1 or more and 2 or less. The difference between the maximum number of fused rings in the hydrocarbon fused-ring skeleton of the first organic compound and the maximum number of fused rings in the hydrocarbon fused-ring skeleton of the light-emitting material may be 1 or more and 8 or less and may be 6 or more and 8 or less. In such a range, the difference between the maximum number of fused rings in the hydrocarbon fused-ring skeleton of the first organic compound and the maximum number of fused rings in the hydrocarbon fused-ring skeleton of the light-emitting material can be larger than the difference between the maximum number of fused rings in the hydrocarbon fused-ring skeleton of the first organic compound and the maximum number of fused rings in the hydrocarbon fused-ring skeleton of the second organic compound. In such a range, the maximum number of fused rings in the hydrocarbon fused-ring skeleton of the first organic compound can be smaller than the maximum number of fused rings in the hydrocarbon fused-ring skeleton of the light-emitting material. This is because the first organic compound can have a larger energy band gap than the light-emitting material.
(5) The hydrocarbon fused-ring skeleton with the maximum number of fused rings in the first organic compound has a perylene moiety.

The effect of improving compatibility by the introduction of an alkyl group described above is high when a material containing a perylene moiety in its molecular structure has a hydrocarbon fused-ring skeleton of 5 or more rings and has a structure with particularly high symmetry.

Specific examples of the first compound include, but are not limited to, the following. Among these, H1 to H12 with a perylene skeleton can particularly be used from the perspective of symmetry.

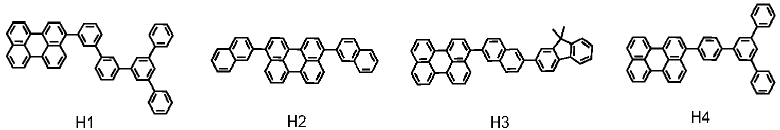

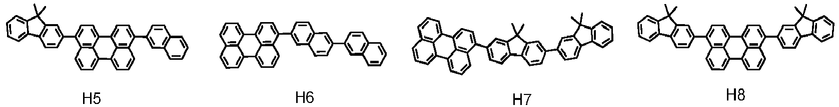

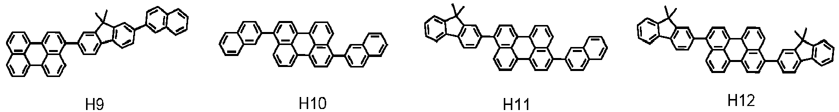

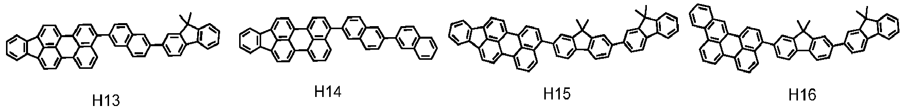

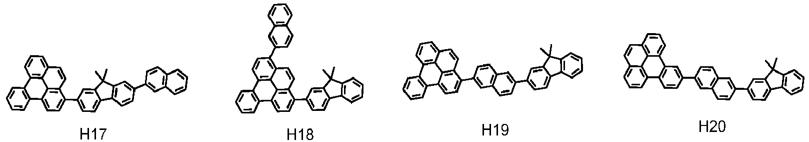

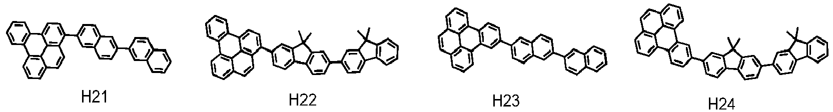

(6) The hydrocarbon fused-ring skeleton with the maximum number of fused rings in the light-emitting material has a perylene moiety.

A light-emitting material having a perylene moiety in its molecular structure has high compatibility with a first organic compound having a perylene moiety in its molecular structure, and the efficiency of energy transfer from the first organic compound (host) to the light-emitting material (guest) is improved. This can increase the light emission efficiency. The light-emitting material can be a red-light-emitting material. This is because a light-emitting material having a perylene moiety in its molecular structure, particularly a light-emitting material in which the maximum number of fused rings in the hydrocarbon fused-ring skeleton is within a particular range, is highly likely to have an energy band gap suitable for a red-light-emitting region. The maximum number of fused rings in the hydrocarbon fused-ring skeleton of the light-emitting material is preferably 8 or more, more preferably 10 or more, still more preferably 13 or more. More specifically, the maximum number of fused rings in the hydrocarbon fused-ring skeleton of the light-emitting material is preferably 8 or more and 20 or less, more preferably 10 or more and 20 or less, still more preferably 11 or more and 16 or less, still more preferably 11 or more and 14 or less. The red-light-emitting region may be 550 nm or more and 800 nm or less, 580 nm or more and 700 nm or less, or 580 nm or more and 680 nm or less.

Specific examples of the red-light-emitting material include, but are not limited to, the following. Among these, RD5 to RD23, which are hydrocarbon compounds with a hydrocarbon fused-ring skeleton, can particularly be used.

Furthermore, the light-emitting material can have an alkyl group. This is because a decrease in intermolecular stacking and intermolecular energy loss improves the light emission efficiency. From this perspective, RD6, RD8, RD11, RD13 to RD16, and RD19 to RD23 can particularly be used.

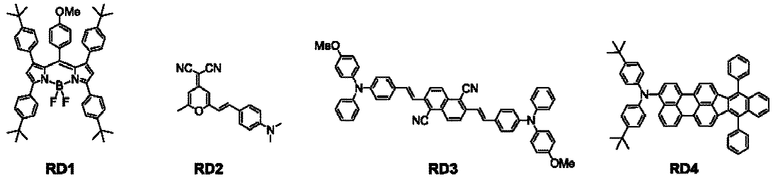

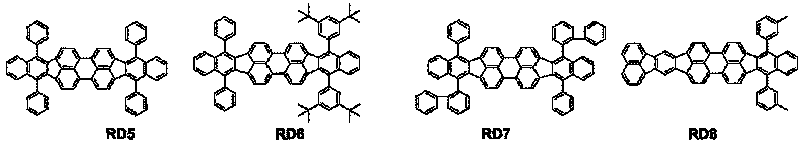

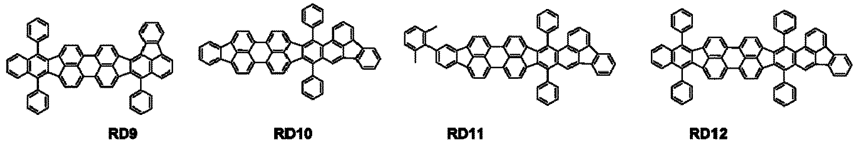

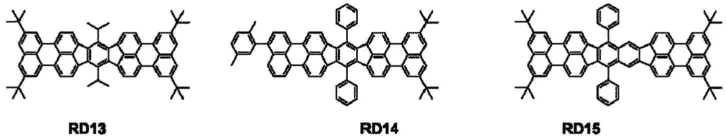

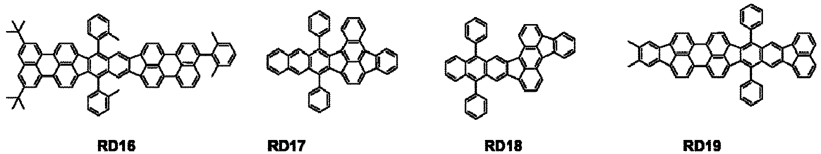

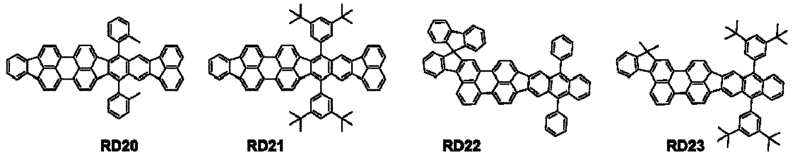

(7) The hydrocarbon fused-ring skeleton with the maximum number of fused rings in the second organic compound has a pyrene moiety.

A material having a pyrene moiety in its structure has high electron mobility and can therefore be used as an adjacent layer in contact with a cathode side of the light-emitting layer, and for the above-described reason can particularly be used when the material has a highly symmetric structure.

Specific examples of the second organic compound include, but are not limited to, the following. Among these, E1 to E20 with a pyrene skeleton can particularly be used from the perspective of symmetry.

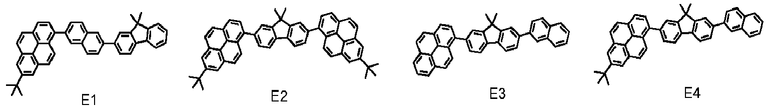

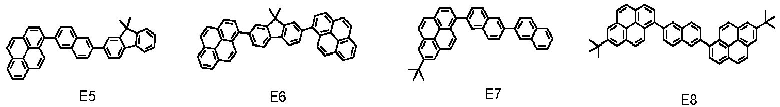

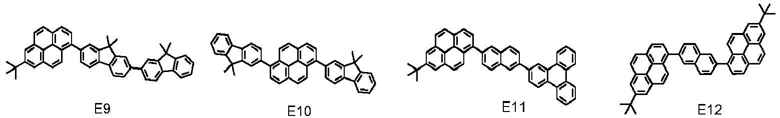

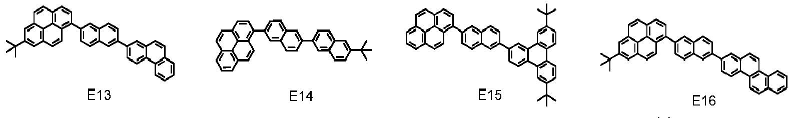

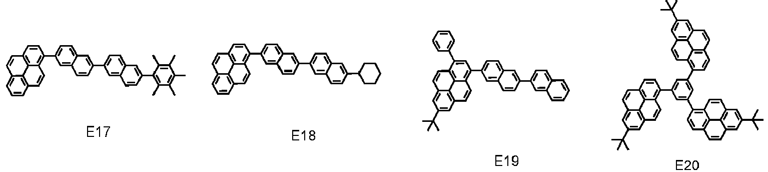

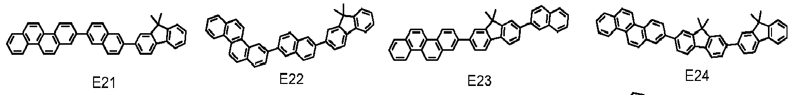

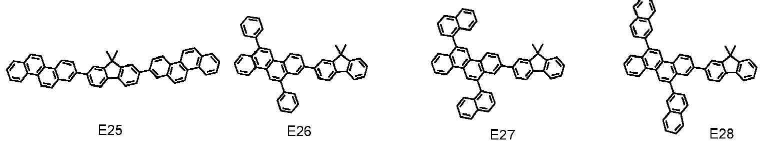

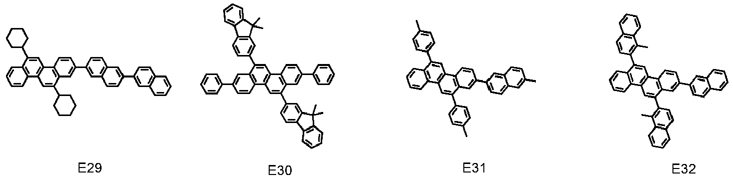

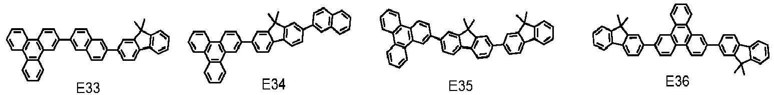

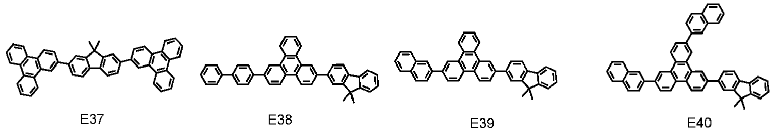

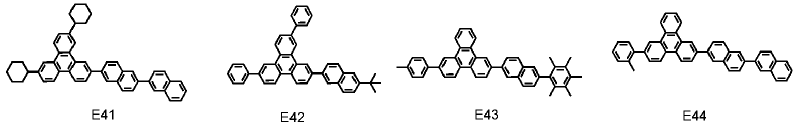

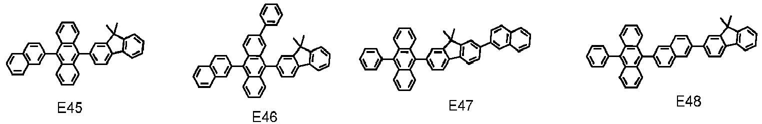

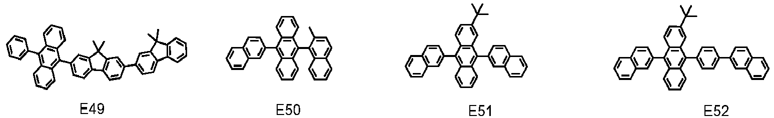

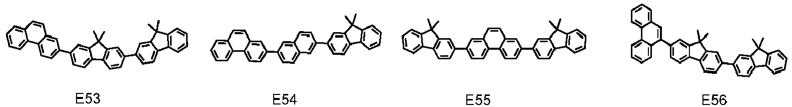

### <Another Structure of Organic Light-Emitting Element>

An organic light-emitting element includes an insulating layer, a first electrode, an organic compound layer, and a second electrode on a substrate. A protective layer, a color filter, a microlens, or the like may be provided on the second electrode. When a color filter is provided, a planarization layer may be provided between the color filter and a protective layer. The planarization layer may be composed of an acrylic resin or the like. The same applies to a planarization layer provided between a color filter and a microlens. One of the first electrode and the second electrode may be an anode, and the other may be a cathode. The emission color of the organic light-emitting element may be red, green, blue, or white.

### [Substrate]

The substrate may be formed of quartz, glass, a silicon wafer, resin, metal, or the like. The substrate may have a switching element, such as a transistor, and wiring, on which an insulating layer may be provided. The insulating layer may be composed of any material, provided that the insulating layer can have a contact hole for wiring between the insulating layer and the first electrode and is insulated from unconnected wires. For example, the insulating layer may be formed of a resin, such as polyimide, silicon oxide, or silicon nitride.

### [Electrode]

A pair of electrodes can be used as electrodes. The pair of electrodes may be an anode and a cathode. When an electric field is applied in a direction in which the organic light-emitting element emits light, an electrode with a high electric potential is an anode, and the other electrode is a cathode. In other words, the electrode that supplies a hole to the light-emitting layer is an anode, and the electrode that supplies an electron to the light-emitting layer is a cathode.

A constituent material of the anode can have as large a work function as possible. Examples thereof include a metal element, such as gold, platinum, silver, copper, nickel, palladium, cobalt, selenium, vanadium, or tungsten, a mixture thereof, an alloy thereof, or a metal oxide, such as tin oxide, zinc oxide, indium oxide, indium tin oxide (ITO), or indium zinc oxide. An electrically conductive polymer, such as polyaniline, polypyrrole, or polythiophene, may also be used.

These electrode materials may be used alone or in combination. The anode may be composed of a single layer or a plurality of layers.

When used as a reflective electrode, for example, chromium, aluminum, silver, titanium, tungsten, molybdenum, an alloy thereof, or a laminate thereof can be used. These materials can also function as a reflective film that does not have a role as an electrode. When used as a transparent electrode, an oxide transparent electroconductive layer, such as indium tin oxide (ITO) or indium zinc oxide, can be used. However, the present disclosure is not limited thereto. The electrodes may be formed by photolithography.

On the other hand, a constituent material of the cathode can be a material with a small work function. For example, an alkali metal, such as lithium, an alkaline-earth metal, such as calcium, a metal element, such as aluminum, titanium, manganese, silver, lead, or chromium, or a mixture thereof may be used. An alloy of these metal elements may also be used. For example, magnesium-silver, aluminum-lithium, aluminum-magnesium, silver-copper, or zinc-silver may be used. A metal oxide, such as indium tin oxide (ITO), may also be used. These electrode materials may be used alone or in combination. The cathode may be composed of a single layer or a plurality of layers. In particular, silver can be used, and a silver alloy can be used to reduce the aggregation of silver. As long as the aggregation of silver can be reduced, the alloy may have any ratio. For example, the ratio of silver to another metal may be 1:1, 3:1, or the like.

The cathode may be, but is not limited to, an oxide electroconductive layer, such as ITO, for a top emission element or a reflective electrode, such as aluminum (Al), for a bottom emission element. The cathode may be formed by any method. A direct-current or alternating-current sputtering method can achieve good film coverage and easily decrease resistance.

### [Organic Compound Layer]

The organic light-emitting element according to the present embodiment may have a hole injection layer, a hole transport layer, an electron-blocking layer, an electron transport layer, an electron injection layer, and the like. Any two or more of the layers may be provided, or any of the layers may be omitted. Although these are described as examples of the organic compound layer, an inorganic compound may also constitute the layer.

Furthermore, an insulating layer, an adhesive layer, or an interference layer may be provided at an interface between an electrode and an organic compound layer, or an electron transport layer or a hole transport layer may be formed of two layers with different ionization potentials.

The organic compound layer according to the present embodiment may be formed as a common layer of a plurality of organic light-emitting elements. The common layer is disposed over a plurality of organic light-emitting elements and can be formed by performing a coating method, such as spin coating, or a vapor deposition method on the entire surface of the substrate.

A material for the hole transport layer can be a material that can facilitate the injection of a hole from an anode or a material with high hole mobility to transport an injected hole to a light-emitting layer. The same material can be used for the hole injection layer and the electron-blocking layer.

Furthermore, a material with a high glass transition temperature can be used to reduce degradation of film quality, such as crystallization, in an organic light-emitting element. Examples of the low-molecular-weight or high-molecular-weight material with high hole mobility include, but are not limited to, a triarylamine derivative, an aryl carbazole derivative, a phenylenediamine derivative, a stilbene derivative, a phthalocyanine derivative, a porphyrin derivative, polyvinyl carbazole, polythiophene, and another electrically conductive polymer. Specific examples of a material that can be used for the hole transport layer include, but are not limited to, the following.

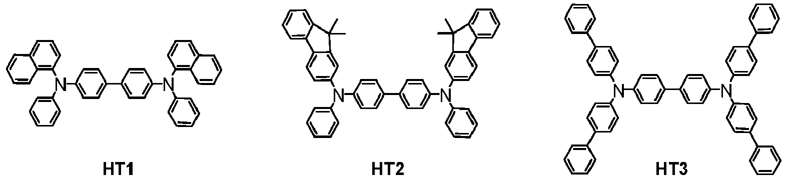

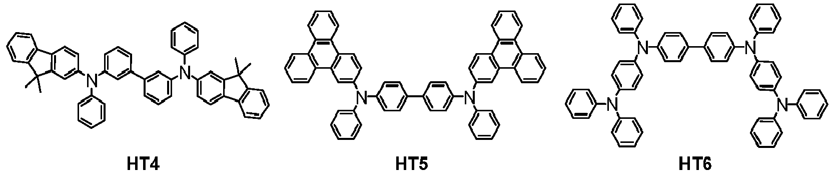

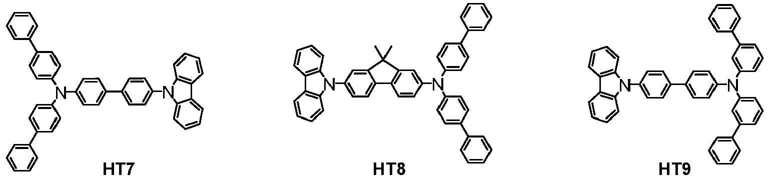

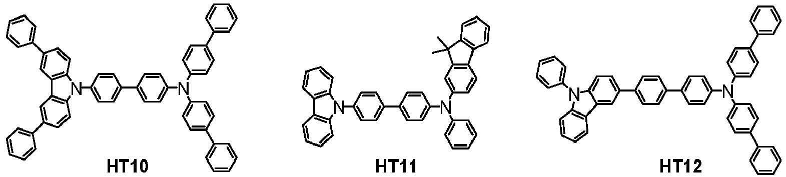

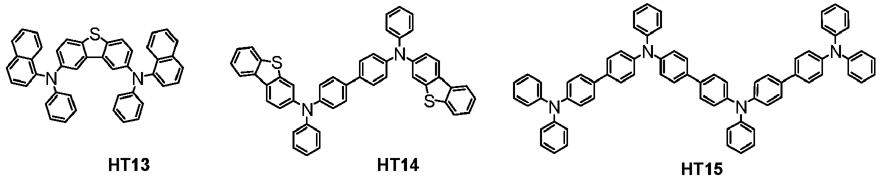

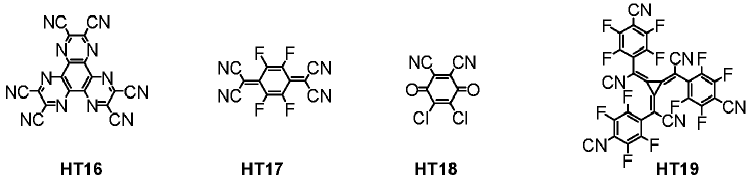

For the hole injection layer, a compound with a deep LUMO, such as a hexaazatriphenylene compound, a tetrafluoroquinodimethane compound, or a dichlorodicyanobenzoquinone compound, can be used. More specifically, the compounds HT16 to HT19 can be mentioned.

For the electron-blocking layer, HT7 to HT12 with a carbazole group can be used. A carbazole group deepens HOMO, and a level at which the HOMO is deepened stepwise in the order of the hole transport material, the hole-blocking material, and the light-emitting layer can be provided, so that a hole can be injected into the light-emitting layer at a low voltage.

An electron transport layer can be selected from layers that can transport an electron to the light-emitting layer and is selected in consideration of the balance with the hole mobility of a hole transport material and the like. Examples of a compound with electron injection ability or electron transport ability include, but are not limited to, oxadiazole derivatives, oxazole derivatives, pyrazine derivatives, triazole derivatives, triazine derivatives, quinoline derivatives, quinoxaline derivatives, phenanthroline derivatives, and organoaluminum complexes. Specific examples of a material that can be used for the electron transport layer include, but are not limited to, the following.

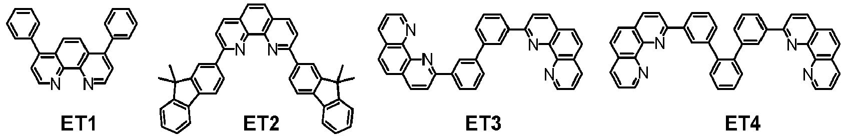

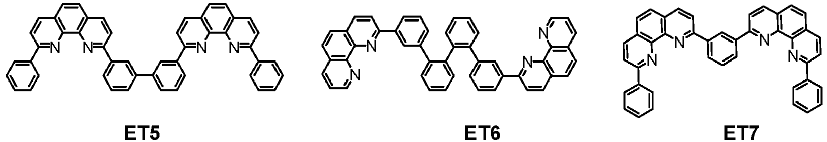

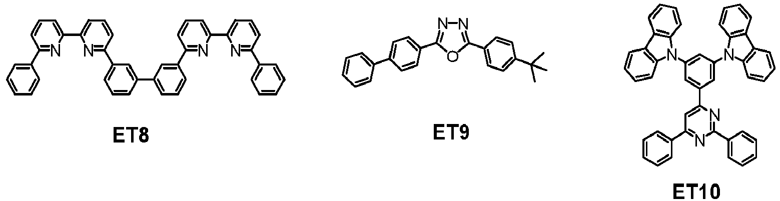

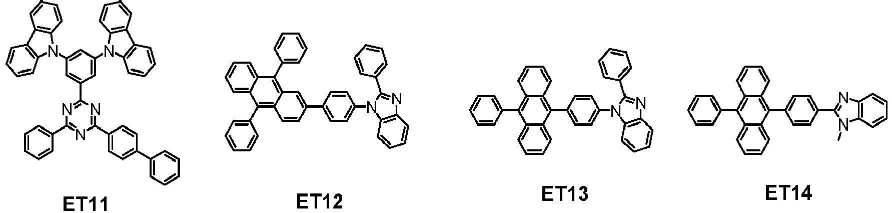

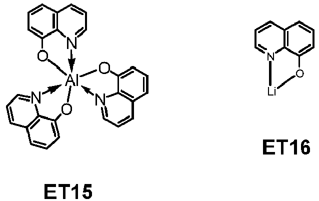

The electron transport layer can be formed of a material having a pyridyl group or a phenanthryl group as a substituent, such as ET1 to ET8. This is because such a compound interacts with an electron injection material or an electrode material, such as an alkali metal compound, and has an effect of lowering the electron injection barrier.

For the electron injection layer, an alkali metal, an alkaline-earth metal, a rare-earth metal, or a compound thereof can be used, and a generally known material can be used. More specifically, metal Ca, LiF, KF, Cs₂CO₃, or the like can be used, and a mixture of electron transport materials may also be used.

An organic compound layer constituting an organic light-emitting element according to an embodiment of the present disclosure can be formed by a dry process, such as a vacuum deposition method, an ionized deposition method, sputtering, or plasma. Instead of the dry process, it is also possible to use a wet process of forming a layer by a known application method (for example, a spin coating method, a casting method, a microgravure coating method, a gravure coating method, a bar coating method, a roll coating method, a wire bar coating method, a dip coating method, a spray coating method, a screen printing method, a flexographic printing method, an offset printing method, an ink jet printing method, a capillary coating method, a nozzle coating method, or the like) using a solution in an appropriate solvent. Among these, a vacuum deposition method, an ionized deposition method, an ink jet printing method, a nozzle coating method, and the like are suitable for the production of an organic light-emitting element with a large area.

A layer formed by a vacuum deposition method, a solution coating method, or the like undergoes little crystallization or the like and has high temporal stability. When a film is formed by a coating method, the film may also be formed in combination with an appropriate binder resin.

The binder resin may be, but is not limited to, a polyvinylcarbazole resin, a polycarbonate resin, a polyester resin, an ABS resin, an acrylic resin, a polyimide resin, a phenolic resin, an epoxy resin, a silicone resin, or a urea resin.

These binder resins may be used alone or in combination as a homopolymer or a copolymer. If necessary, an additive agent, such as a known plasticizer, oxidation inhibitor, and/or ultraviolet absorbent, may also be used.

In general, each layer of the organic light-emitting element preferably has a thickness of 1 nm or more and 10 µm or less. In particular, the light-emitting layer of the organic compound layer preferably has a thickness of 10 nm or more and 100 nm or less to achieve effective emission properties.

### [Protective Layer]

A protective layer may be provided on the second electrode. For example, a glass sheet with a moisture absorbent may be attached to the second electrode to decrease the amount of water or the like entering the organic compound layer and to reduce the occurrence of display defects. In another embodiment, a passivation film of silicon nitride or the like may be provided on the second electrode to decrease the amount of water or the like entering the organic compound layer. For example, the second electrode may be formed and then transferred to another chamber without breaking the vacuum, and a silicon nitride film with a thickness of 2 µm may be formed as a protective layer by a chemical vapor deposition (CVD) method. The film formation by the CVD method may be followed by the formation of a protective layer by an atomic layer deposition (ALD) method. A film formed by the ALD method may be formed of any material, such as silicon nitride, silicon oxide, or aluminum oxide. Silicon nitride may be further formed by the CVD method on the film formed by the ALD method. The film formed by the ALD method may have a smaller thickness than the film formed by the CVD method. More specifically, the thickness may be 50% or less or even 10% or less.

### [Color Filter]

A color filter may be provided on the protective layer. For example, a color filter that matches the size of the organic light-emitting element may be provided on another substrate and may be bonded to the substrate on which the organic light-emitting element is provided, or a color filter may be patterned on the protective layer by photolithography. The color filter may be composed of a polymer.

### [Planarization Layer]

A planarization layer may be provided between the color filter and the protective layer. The planarization layer is provided to reduce the roughness of the underlayer. The planarization layer is sometimes referred to as a material resin layer with any purpose. The planarization layer may be composed of an organic compound and can be composed of a high-molecular-weight compound, though it may be composed of a low-molecular-weight compound.

The planarization layer may be provided above and below the color filter, and the constituent materials thereof may be the same or different. Specific examples include a polyvinylcarbazole resin, a polycarbonate resin, a polyester resin, an ABS resin, an acrylic resin, a polyimide resin, a phenolic resin, an epoxy resin, a silicone resin, and a urea resin.

### [Microlens]

An organic light-emitting element may include an optical member, such as a microlens, on the light output side. The microlens may be composed of an acrylic resin, an epoxy resin, or the like. The microlens may be used to increase the amount of light extracted from the organic light-emitting element and to control the direction of the extracted light. The microlens may have a hemispherical shape. For a hemispherical microlens, the vertex of the microlens is a contact point between the hemisphere and a tangent line parallel to the insulating layer among the tangent lines in contact with the hemisphere. The vertex of the microlens in any cross-sectional view can be determined in the same manner. More specifically, the vertex of the microlens in a cross-sectional view is a contact point between the semicircle of the microlens and a tangent line parallel to the insulating layer among the tangent lines in contact with the semicircle.

The midpoint of the microlens can also be defined. In a cross section of the microlens, a midpoint of a line segment from one end point to the other end point of the arc can be referred to as a midpoint of the microlens. A cross section in which the vertex and the midpoint are determined may be perpendicular to the insulating layer.

### [Opposite Substrate]

An opposite substrate may be provided on the planarization layer. The opposite substrate is so called because it faces the substrate. The opposite substrate may be composed of the same material as the substrate. When the substrate is a first substrate, the opposite substrate may be a second substrate.

### [Pixel Circuit]

An organic light-emitting apparatus including an organic light-emitting element may include a pixel circuit coupled to the organic light-emitting element. The pixel circuit may be of an active matrix type, which independently controls the light emission of a first light-emitting element and a second light-emitting element. The active-matrix circuit may be voltage programmed or current programmed. The drive circuit has a pixel circuit for each pixel. The pixel circuit may include a light-emitting element, a transistor for controlling the luminous brightness of the light-emitting element, a transistor for controlling light emission timing, a capacitor for holding the gate voltage of the transistor for controlling the luminous brightness, and a transistor for GND connection without through the light-emitting element.

A light-emitting apparatus includes a display region and a peripheral region around the display region. The display region includes the pixel circuit, and the peripheral region includes a display control circuit. The mobility of a transistor constituting the pixel circuit may be smaller than the mobility of a transistor constituting the display control circuit. The gradient of the current-voltage characteristics of a transistor constituting the pixel circuit may be smaller than the gradient of the current-voltage characteristics of a transistor constituting the display control circuit. The gradient of the current-voltage characteristics can be determined by so-called Vg-Ig characteristics. A transistor constituting the pixel circuit is a transistor coupled to a light-emitting element, such as a first light-emitting element.

### [Pixel]

An organic light-emitting apparatus including an organic light-emitting element may have a plurality of pixels. Each pixel has subpixels that emit light of different colors. For example, the subpixels may have RGB emission colors.

In each pixel, a region also referred to as a pixel aperture emits light. This region is the same as the first region. The pixel aperture may be 15 µm or less or 5 µm or more. More specifically, the pixel aperture may be 11 µm, 9.5 µm, 7.4 µm, or 6.4 µm. The distance between the subpixels may be 10 µm or less, more specifically, 8 µm, 7.4 µm, or 6.4 µm.

The pixels may be arranged in a known form in a plan view. Examples include a stripe arrangement, a delta arrangement, a PenTile arrangement, and a Bayer arrangement. Each subpixel may have any known shape in a plan view. Examples include quadrangles, such as a rectangle and a rhombus, and a hexagon. As a matter of course, the rectangle also includes a figure that is not strictly rectangular but is close to rectangular. The shape of each subpixel and the pixel array can be used in combination.

### <Applications of Organic Light-Emitting Element>

The organic light-emitting element according to the present embodiment can be used as a constituent of a display apparatus or a lighting apparatus. Other applications include an exposure light source for an electrophotographic image-forming apparatus, a backlight for a liquid crystal display, and a light-emitting apparatus with a color filter in a white light source.

The display apparatus may be an image-information-processing apparatus that includes an image input unit for inputting image information from an area CCD, a linear CCD, a memory card, or the like, includes an information processing unit for processing the input information, and displays an input image on a display unit. The display apparatus may have a plurality of pixels, and at least one of the pixels may include the organic light-emitting element according to the present embodiment and an active element, such as a transistor, coupled to the organic light-emitting element. The substrate may be a semiconductor substrate formed of silicon or the like, and the transistor may be a MOSFET formed on the substrate. The image display apparatus includes an input portion for inputting image information and a display unit for outputting an image, and the display unit includes the display apparatus according to the present embodiment.

A display unit of an imaging apparatus or an inkjet printer may have a touch panel function. A driving system of the touch panel function may be, but is not limited to, an infrared radiation system, an electrostatic capacitance system, a resistive film system, or an electromagnetic induction system. The display apparatus may be used for a display unit of a multifunction printer.

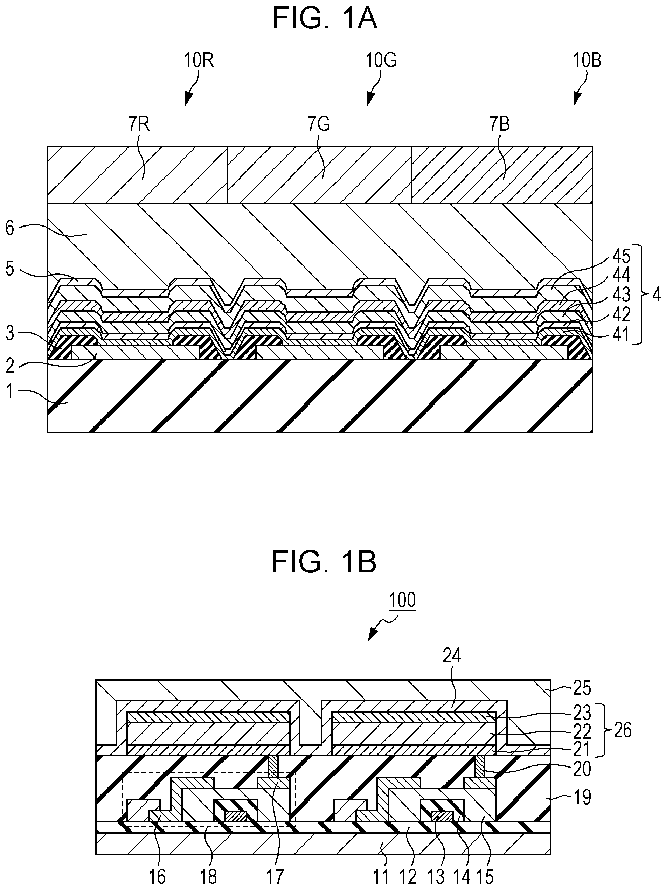

Next, a display apparatus according to the present embodiment is described below with reference to the accompanying drawings. Figs. 1A and 1B are schematic cross-sectional views of an example of a display apparatus that includes an organic light-emitting element and a transistor coupled to the organic light-emitting element. The transistor is an example of an active element. The transistor may be a thin-film transistor (TFT).

Fig. 1A is a schematic cross-sectional view of an example of a pixel serving as a constructional element of the display apparatus according to the present embodiment. The pixel has subpixels 10. The subpixels are 10R, 10G, and 10B with different emission colors. The emission colors may be distinguished by the wavelength of light emitted from the light-emitting layer, or light emitted from each subpixel may be selectively transmitted or color-converted with a color filter or the like. Each of the subpixels 10 includes a reflective electrode serving as a first electrode 2, an insulating layer 3 covering an end of the first electrode 2, organic compound layers 4 covering the first electrode 2 and the insulating layer 3, a transparent electrode serving as a second electrode 5, a protective layer 6, and a color filter 7 on an interlayer insulating layer 1.

A transistor and/or a capacitor element may be provided under or inside the interlayer insulating layer 1. The transistor and the first electrode 2 may be electrically connected via a contact hole (not shown) or the like.

The insulating layer 3 is also referred to as a bank or a pixel separation film. The insulating layer 3 covers the ends of the first electrode 2 and surrounds the first electrode 2. A portion not covered with the insulating layer 3 is in contact with the organic compound layers 4 and serves as a light-emitting region.

The organic compound layers 4 include a hole injection layer 41, a hole transport layer 42, a first light-emitting layer 43, a hole-blocking layer (adjacent layer) 44, and an electron transport layer 45.

The second electrode 5 may be a transparent electrode, a reflective electrode, or a semitransparent electrode.

The protective layer 6 reduces the penetration of moisture into the organic compound layers 4. The protective layer 6 is illustrated as a single layer but may be a plurality of layers. The protective layer 6 may include an inorganic compound layer and an organic compound layer.

The color filter 7 is divided into 7R, 7G, and 7B according to the color. The color filter 7 may be formed on a planarization film (not shown). Furthermore, a resin protective layer (not shown) may be provided on the color filter 7. The color filter 7 may be formed on the protective layer 6. Alternatively, the color filter 7 may be bonded after being provided on an opposite substrate, such as a glass substrate.

A display apparatus 100 illustrated in Fig. 1B includes an organic light-emitting element 26 and a TFT 18, which is an example of a transistor. The display apparatus includes a substrate 11 made of glass, silicon, or the like and an insulating layer 12 on the substrate 11. An active element, such as the TFT 18, and a gate electrode 13, a gate-insulating film 14, and a semiconductor layer 15 of the active element are disposed on the insulating layer 12. The TFT 18 has a drain electrode 16 and a source electrode 17. The TFT 18 is covered with an insulating film 19. An anode 21 of the organic light-emitting element 26 is coupled to the source electrode 17 through a contact hole 20 formed in the insulating film 19.

Electrical connection between the electrodes of the organic light-emitting element 26 (the anode 21 and a cathode 23) and the electrodes of the TFT 18 (the source electrode 17 and the drain electrode 16) is not limited to that illustrated in Fig. 1B. More specifically, it is only necessary to electrically connect either the anode 21 or the cathode 23 to either the source electrode 17 or the drain electrode 16 of the TFT 18.

Although an organic compound layer 22 is a single layer in the display apparatus 100 illustrated in Fig. 1B, the organic compound layer 22 may be composed of a plurality of layers. The cathode 23 is covered with a first protective layer 24 and a second protective layer 25 for reducing degradation of the organic light-emitting element 26.

The transistor used as a switching element in the display apparatus 100 illustrated in Fig. 1B may be replaced with another switching element, such as a metal insulator metal (MIM) element.

The transistor used in the display apparatus 100 in Fig. 1B is not limited to a thin-film transistor including an active layer on an insulating surface of a substrate and may also be a transistor including a single crystal silicon wafer. The active layer may be single-crystal silicon, non-single-crystal silicon, such as amorphous silicon or microcrystalline silicon, or a non-single-crystal oxide semiconductor, such as indium zinc oxide or indium gallium zinc oxide. The thin-film transistor is also referred to as a TFT element.

The transistor in the display apparatus 100 of Fig. 1B may be formed within a substrate, such as a Si substrate. The phrase "formed within a substrate" means that the substrate, such as a Si substrate, itself is processed to form the transistor. Thus, the transistor within the substrate can be considered that the substrate and the transistor are integrally formed.

In the organic light-emitting element according to the present embodiment, the luminous brightness is controlled with the TFT, which is an example of a switching element. The organic light-emitting element can be provided in a plurality of planes to display an image at each luminous brightness. The switching element according to the present embodiment is not limited to the TFT and may be a transistor formed of low-temperature polysilicon or an active-matrix driver formed on a substrate, such as a Si substrate. The phrase "on a substrate" may also be referred to as "within a substrate". Whether a transistor is provided within a substrate or a TFT is used depends on the size of a display unit. For example, for an approximately 0.5-inch display unit, an organic light-emitting element can be provided on a Si substrate.

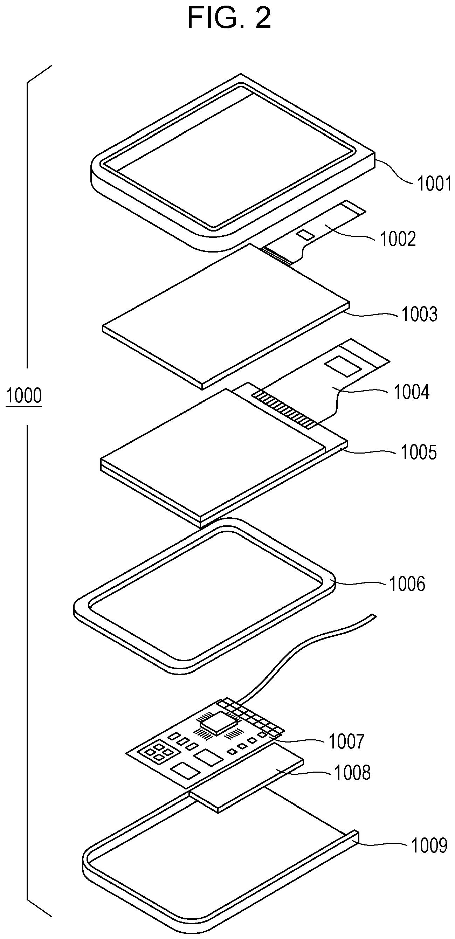

Fig. 2 is a schematic view of an example of a display apparatus according to the present embodiment. A display apparatus 1000 may include a touch panel 1003, a display panel 1005, a frame 1006, a circuit substrate 1007, and a battery 1008 between an upper cover 1001 and a lower cover 1009. The touch panel 1003 and the display panel 1005 are coupled to flexible print circuits FPC 1002 and 1004, respectively. Transistors are printed on the circuit substrate 1007. The battery 1008 is not necessarily provided when the display apparatus is not a mobile device, or may be provided at another position even when the display apparatus is a mobile device.

The display apparatus according to the present embodiment may include color filters of red, green, and blue colors. In the color filters, the red, green, and blue colors may be arranged in a delta arrangement.

The display apparatus according to the present embodiment may be used for a display unit of a mobile terminal. Such a display apparatus may have both a display function and an operation function. Examples of the mobile terminal include mobile phones, such as smartphones, tablets, and head-mounted displays.

The display apparatus according to the present embodiment may be used for a display unit of an imaging apparatus that includes an optical unit with a plurality of lenses and an imaging element for receiving light passing through the optical unit. The imaging apparatus may include a display unit for displaying information acquired by the imaging element. The display unit may be a display unit exposed outside from the imaging apparatus or a display unit located in a finder. The imaging apparatus may be a digital camera or a digital video camera.

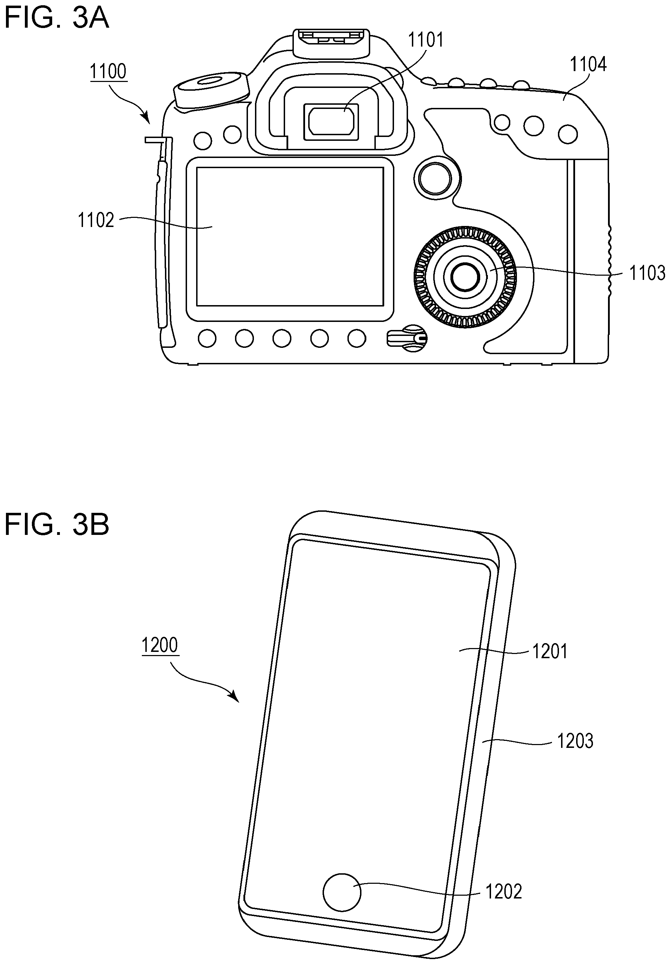

Fig. 3A is a schematic view of an example of an imaging apparatus according to the present embodiment. An imaging apparatus 1100 may include a viewfinder 1101, a rear display 1102, an operating unit 1103, and a housing 1104. The viewfinder 1101 may include the display apparatus according to the present embodiment. In such a case, the display apparatus may display environmental information, imaging instructions, and the like as well as an image to be captured. The environmental information may include the intensity of external light, the direction of external light, the travel speed of the photographic subject, the possibility that the photographic subject is shielded by a shielding material, and the like.

Because the appropriate timing for imaging is a short time, it is better to display information as early as possible. Thus, a display apparatus including the organic light-emitting element according to the present embodiment can be used. This is because the organic light-emitting element has a high response speed. A display apparatus including the organic light-emitting element can be more suitably used than these apparatuses and liquid crystal displays that require a high display speed.

The imaging apparatus 1100 includes an optical unit (not shown). The optical unit has a plurality of lenses and focuses an image on an imaging element in the housing 1104. The focus of the lenses can be adjusted by adjusting their relative positions. This operation can also be automatically performed. The imaging apparatus may also be referred to as a photoelectric conversion apparatus. The photoelectric conversion apparatus can have, as an imaging method, a method of detecting a difference from a previous image, a method of cutting out a permanently recorded image, or the like, instead of taking an image one after another.

Fig. 3B is a schematic view of an example of electronic equipment according to the present embodiment. Electronic equipment 1200 includes a display unit 1201, an operating unit 1202, and a housing 1203. The housing 1203 may include a circuit, a printed circuit board including the circuit, a battery, and a communication unit. The operating unit 1202 may be a button or a touch panel response unit. The operating unit 1202 may be a biometric recognition unit that recognizes a fingerprint and releases the lock. Electronic equipment with a communication unit may also be referred to as communication equipment. The electronic equipment 1200 may have a lens and an imaging element and thereby further have a camera function. An image captured by the camera function is displayed on the display unit 1201. The electronic equipment 1200 may be a smartphone, a notebook computer, or the like.

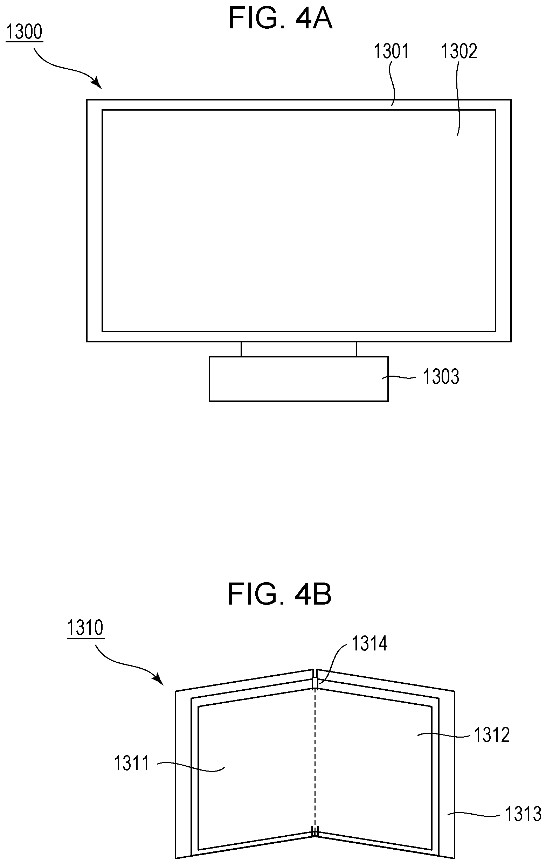

Figs. 4A and 4B are schematic views of an example of a display apparatus according to the present embodiment. Fig. 4A illustrates a display apparatus, such as a television monitor or a PC monitor. A display apparatus 1300 includes a frame 1301 and a display unit 1302. The light-emitting element according to the present embodiment may be used for the display unit 1302. The display apparatus 1300 includes a base 1303 for supporting the frame 1301 and the display unit 1302. The base 1303 is not limited to the structure illustrated in Fig. 4A. The lower side of the frame 1301 may also serve as the base. The frame 1301 and the display unit 1302 may be bent. The radius of curvature thereof may be 5000 mm or more and 6000 mm or less.

Fig. 4B is a schematic view of another example of the display apparatus according to the present embodiment. A display apparatus 1310 in Fig. 4B is configured to be foldable and is a so-called foldable display apparatus. The display apparatus 1310 includes a first display unit 1311, a second display unit 1312, a housing 1313, and a folding point 1314. The first display unit 1311 and the second display unit 1312 may include the light-emitting element according to the present embodiment. The first display unit 1311 and the second display unit 1312 may be a single display apparatus without a joint. The first display unit 1311 and the second display unit 1312 can be divided by the folding point. The first display unit 1311 and the second display unit 1312 may display different images or one image.

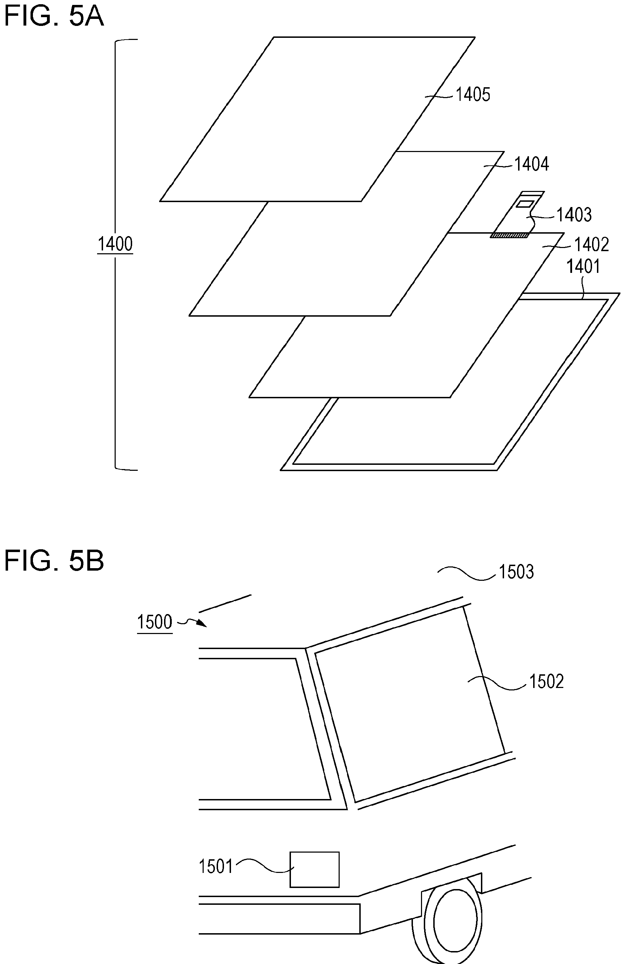

Fig. 5A is a schematic view of an example of a lighting apparatus according to the present embodiment. A lighting apparatus 1400 may include a housing 1401, a light source 1402, a circuit substrate 1403, an optical filter 1404 that transmits light emitted by the light source 1402, and a light-diffusing unit 1405. The light source 1402 may include the organic light-emitting element according to the present embodiment. The optical filter 1404 may be a filter that improves the color rendering properties of the light source. The light-diffusing unit 1405 can effectively diffuse light from the light source and widely spread light as in illumination. The optical filter 1404 and the light-diffusing unit 1405 may be provided on the light output side of the lighting apparatus. If necessary, a cover may be provided on the outermost side.

For example, the lighting apparatus is an interior lighting apparatus. The lighting apparatus may emit white light, neutral white light, or light of any color from blue to red. The lighting apparatus may have a light control circuit for controlling such light or a color control circuit for controlling emission color. The lighting apparatus may include the organic light-emitting element according to the present embodiment and a power supply circuit coupled thereto. The power supply circuit is a circuit that converts an AC voltage to a DC voltage. The lighting apparatus may have an inverter circuit. White has a color temperature of 4200 K, and neutral white has a color temperature of 5000 K. The lighting apparatus may have a color filter.

The lighting apparatus according to the present embodiment may include a heat dissipation unit. The heat dissipation unit releases heat from the apparatus to the outside and may be a metal or liquid silicon with a high specific heat.

Fig. 5B is a schematic view of an automobile as an example of a moving body according to the present embodiment. The automobile has a taillight as an example of a lamp. An automobile 1500 may have a taillight 1501, which comes on when a brake operation or the like is performed.

The taillight 1501 may include the organic light-emitting element according to the present embodiment. The taillight 1501 may include a protective member for protecting the organic light-emitting element. The protective member may be formed of any transparent material with moderately high strength and can be formed of polycarbonate or the like. The polycarbonate may be mixed with a furan dicarboxylic acid derivative, an acrylonitrile derivative, or the like.

The automobile 1500 may have a body 1503 and a window 1502 on the body 1503. The window 1502 may be a transparent display as long as it is not a window for checking the front and rear of the automobile. The transparent display may include the organic light-emitting element according to the present embodiment. In such a case, constituent materials, such as electrodes, of the organic light-emitting element are transparent materials.

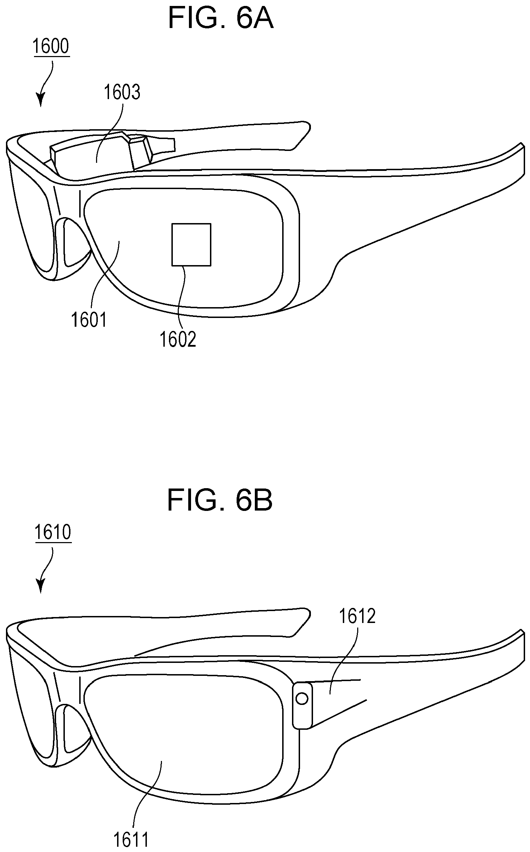

Application examples of the display apparatus according to one of the embodiments are described below with reference to Figs. 6A and 6B. The display apparatus can be applied to a system that can be worn as a wearable device, such as smart glasses, a head-mounted display (HMD), or smart contact lenses. An imaging and displaying apparatus used in such an application example includes an imaging apparatus that can photoelectrically convert visible light and a display apparatus that can emit visible light.

The moving body according to the present embodiment may be a ship, an aircraft, a drone, or the like. The moving body may include a body and a lamp provided on the body. The lamp may emit light to indicate the position of the body. The lamp includes the organic light-emitting element according to the present embodiment.

Fig. 6A is a schematic view of an example of a wearable device according to an embodiment of the present disclosure. Glasses 1600 (smart glasses) according to one application example are described below with reference to Fig. 6A. An imaging apparatus 1602, such as a complementary metal-oxide semiconductor (CMOS) sensor or a single-photon avalanche photodiode (SPAD), is provided on the front side of a lens 1601 of the glasses 1600. The display apparatus according to one of the embodiments is provided on the back side of the lens 1601.

The glasses 1600 further include a controller 1603. The controller 1603 functions as a power supply for supplying power to the imaging apparatus 1602 and the display apparatus. The controller 1603 controls the operation of the imaging apparatus 1602 and the display apparatus. The lens 1601 has an optical system for focusing light on the imaging apparatus 1602.

Fig. 6B is a schematic view of another example of a wearable device according to an embodiment of the present disclosure. Glasses 1610 (smart glasses) according to one application example are described below with reference to Fig. 6B. The glasses 1610 have a controller 1612, which includes an imaging apparatus corresponding to the imaging apparatus 1602 of Fig. 6A and a display apparatus. A lens 1611 includes an optical system for projecting light from the imaging apparatus of the controller 1612 and the display apparatus, and an image is projected on the lens 1611. The controller 1612 functions as a power supply for supplying power to the imaging apparatus and the display apparatus and controls the operation of the imaging apparatus and the display apparatus.

The controller 1612 may include a line-of-sight detection unit for detecting the line of sight of the wearer. Infrared radiation may be used to detect the line of sight. An infrared radiation unit emits infrared light to an eyeball of a user who is gazing at a display image. Reflected infrared light from the eyeball is detected by an imaging unit including a light-receiving element to capture an image of the eyeball. A reduction unit for reducing light from the infrared radiation unit to a display unit in a plan view is provided to reduce degradation in image quality. The line of sight of the user for the display image is detected from the image of the eyeball captured by infrared imaging. Any known technique can be applied to line-of-sight detection using the captured image of the eyeball. For example, it is possible to use a line-of-sight detection method based on a Purkinje image obtained by the reflection of irradiation light by the cornea. More specifically, a line-of-sight detection process based on a pupil-corneal reflection method is performed. The line of sight of the user is detected by calculating a line-of-sight vector representing the direction (rotation angle) of an eyeball on the basis of an image of a pupil and a Purkinje image included in a captured image of the eyeball using the pupil-corneal reflection method.

A display apparatus according to an embodiment of the present disclosure may include an imaging apparatus including a light-receiving element and may control a display image on the basis of line-of-sight information of a user from the imaging apparatus. More specifically, on the basis of the line-of-sight information, the display apparatus determines a first visibility region at which the user gazes and a second visibility region other than the first visibility region. The first visibility region and the second visibility region may be determined by the controller of the display apparatus or may be received from an external controller. In the display region of the display apparatus, the first visibility region may be controlled to have higher display resolution than the second visibility region. In other words, the second visibility region may have lower resolution than the first visibility region.

The display region has a first display region and a second display region different from the first display region, and the priority of the first display region and the second display region depends on the line-of-sight information. The first visibility region and the second visibility region may be determined by the controller of the display apparatus or may be received from an external controller. A region with a higher priority may be controlled to have higher resolution than another region. In other words, a region with a lower priority may have lower resolution.

The first visibility region or a region with a higher priority may be determined by artificial intelligence (AI). The AI may be a model configured to estimate the angle of the line of sight and the distance to a target ahead of the line of sight from an image of an eyeball using the image of the eyeball and the direction in which the eyeball actually viewed in the image as teaching data. The AI program may be stored in the display apparatus, the imaging apparatus, or an external device. The AI program stored in an external device is transmitted to the display apparatus via communication.

For display control based on visual recognition detection, the present disclosure can be applied to smart glasses further having an imaging apparatus for imaging the outside. Smart glasses can display captured external information in real time.

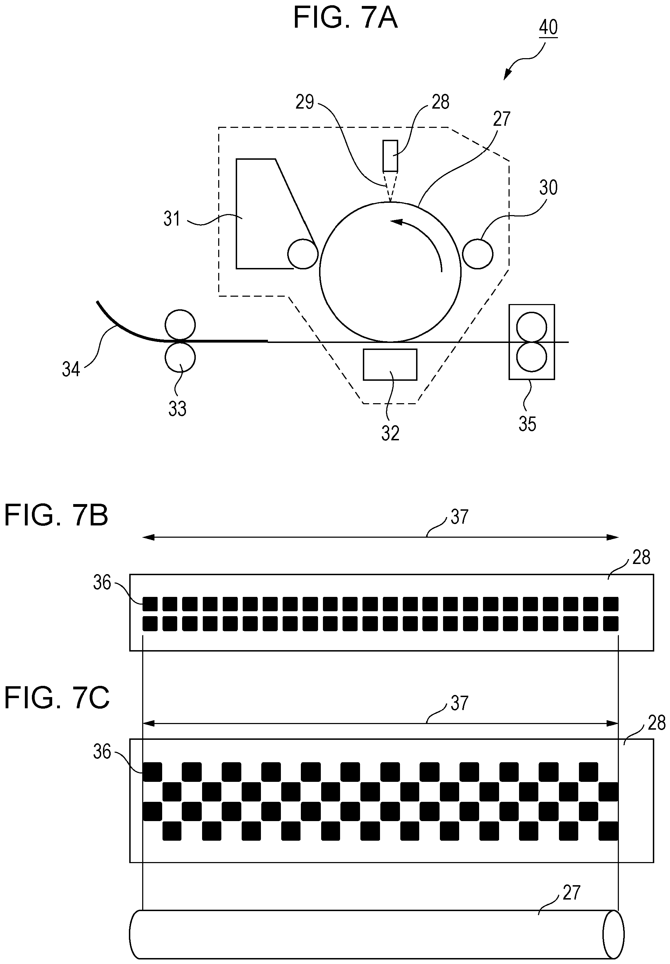

Fig. 7A is a schematic view of an example of an image-forming apparatus according to an embodiment of the present disclosure. An image-forming apparatus 40 is an electrophotographic image-forming apparatus and includes a photosensitive member 27, an exposure light source 28, a charging unit 30, a developing unit 31, a transfer unit 32, a conveying roller 33, and a fixing unit 35. The exposure light source 28 emits light 29, and an electrostatic latent image is formed on the surface of the photosensitive member 27. The exposure light source 28 includes the organic light-emitting element according to the present embodiment. The developing unit 31 contains toner and the like. The charging unit 30 electrifies the photosensitive member 27. The transfer unit 32 transfers a developed image onto a recording medium 34. The conveying roller 33 conveys the recording medium 34. The recording medium 34 is paper, for example. The fixing unit 35 fixes an image on the recording medium 34.

Figs. 7A and 7B are schematic views of the exposure light source 28, wherein a plurality of light-emitting portions 36 are arranged on a long substrate. An arrow 37 indicates a direction parallel to the axis of the photosensitive member and indicates a column direction in which the organic light-emitting elements are arranged. This column direction is the same as the direction of the rotation axis of the photosensitive member 27. This direction can also be referred to as the major-axis direction of the photosensitive member 27. In Fig. 7B, the light-emitting portions 36 are arranged in the major-axis direction of the photosensitive member 27. In Fig. 7C, unlike Fig. 7B, the light-emitting portions 36 are alternately arranged in the column direction in the first and second columns. The first and second columns are arranged at different positions in the row direction. In the first column, the light-emitting portions 36 are arranged at intervals. In the second column, the light-emitting portions 36 are arranged at positions corresponding to the spaces between the light-emitting portions 36 of the first column. Thus, the light-emitting portions 36 are also arranged at intervals in the row direction. The arrangement in Fig. 7C can also be referred to as a grid-like pattern, a staggered pattern, or a checkered pattern, for example.

As described above, an apparatus including the organic light-emitting element according to the present embodiment can be used to stably display a high-quality image for extended periods. Furthermore, an apparatus including the organic light-emitting element according to the present embodiment can be used to achieve both good visibility outdoors and power-saving display due to high-efficiency and high-luminance light output.

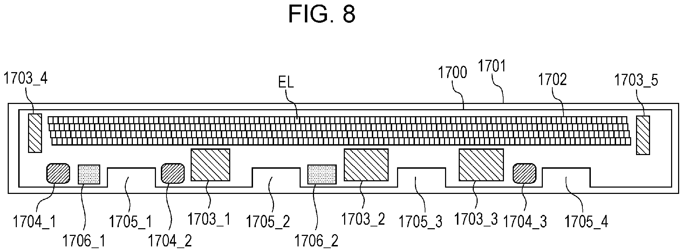

Fig. 8 is a schematic view of one form of a light-emitting device according to the present embodiment. The light-emitting device according to the present embodiment can be used, for example, as a light source of an image-forming apparatus. The light-emitting device according to the present embodiment has a rectangular shape with a long side parallel to a first direction and a short side parallel to a direction across the first direction. For example, the first direction may be a direction along a rotation axis direction of a photosensitive member of an image-forming apparatus.

A substrate 1701 has a polygonal shape, and an example of a rectangular substrate 1701 is described below. In the present specification, a long-side direction of the rectangular substrate 1701 is referred to as a first direction, and a short-side direction perpendicular to the long-side direction is referred to as a second direction. The polygonal shape in the present specification also includes a shape with rounded corners. A moisture-resistant ring 1700 is disposed on the rectangular substrate 1701 to suppress and prevent water from entering the light-emitting device. The moisture-resistant ring 1700 may be, for example, a guard ring composed of a wiring layer.

A light-emitting region 1702, a contact region 1703, a pad 1704, and a circuit 1706 are arranged inside the moisture-resistant ring 1700. In the present embodiment, the contact region 1703 includes a first contact region 1703_1, a second contact region 1703_2, a third contact region 1703_3, a fourth contact region 1703_4, and a fifth contact region 1703_5. The pad 1704 includes a first pad 1704_1, a second pad 1704_2, and a third pad 1704_3.

The circuit 1706 is a circuit for driving each light-emitting device and includes a circuit 1706_1 and a circuit 1706_2. Specific examples of the circuits 1706_1 and 1706_2 include, but are not limited to, an input protection circuit, an input circuit to which data for driving is input, a logic circuit for processing data, and the like.

Light-emitting elements EL are arranged in rows and columns in the light-emitting region 1702. The contact region 1703 is a region where wiring electrically connected to the common electrode of the light-emitting elements EL is provided. The pad 1704_1 electrically connects the contact region 1703 to an external element.

The outer peripheral shape of the moisture-resistant ring 1700 may include a plurality of hollows (recessed portions 1705). This portion can be used, for example, as an abutting region on which a rib, which is a portion of a mask for vapor deposition in a film-forming step, abuts.

As described above, each of the light-emitting elements EL arranged in a matrix in the light-emitting region 1702 is composed of a light-emitting layer and a first electrode and a second electrode that hold the light-emitting layer therebetween. In the present embodiment, an example is shown in which the first electrode is an independent electrode provided in each of the light-emitting elements EL, and the second electrode is a common electrode provided in common to the light-emitting elements EL.

For example, when the light-emitting elements EL are arranged in four rows in the light-emitting region 1702, as illustrated in Fig. 8, the initial position of the light-emitting element EL in the first row may be shifted in the X direction by one fourth of the dimension of the light-emitting element EL in the X direction (the first direction) from the initial position of the light-emitting element EL in the second row. For n rows, where n is an integer of 2 or more, the initial position of the light-emitting element EL in the first row may be shifted in the X direction by 1/n of the dimension of the light-emitting element EL in the X direction from the initial position of the light-emitting element EL in the second row. Such a structure is advantageous for improving resolution.

The contact region 1703 is a region adjacent to the light-emitting region 1702 of the substrate 1701 and is arranged inside the moisture-resistant ring 1700. At least one of the contact region 1703, the pad 1704, and the circuit 1706 may be disposed between the light-emitting region 1702 and one long-side end portion of the substrate 1701 together with the recessed portions 1705 of the moisture-resistant ring 1700 and may be arranged in series with respect to the long-side direction.

Thus, when the contact region 1703, the pad 1704, the circuit 1706, and the like are provided at the same position in the short-side direction, this can reduce the length of the light-emitting device in the short-side direction and the size of the light-emitting device.

The light-emitting device according to the present embodiment has a plurality of contact regions 1703 between the common electrode of the light-emitting elements EL and power supply wiring along the long side edge of the light-emitting device. When the common electrode is composed of, for example, a transparent electrode material with a relatively high electrical resistance, the voltage drop may increase in the long-side direction. Thus, the voltage applied to each light-emitting element EL varies with the distance from the contact region 1703 to which the electric potential is supplied. This may result in different actual luminous brightness between the light-emitting elements EL to which a voltage for emitting light with the same luminance is applied, and cause shading or the like. A plurality of contact regions 1703 in the long-side direction as in the present embodiment can reduce a voltage drop of the common electrode in the long-side direction and reduce the occurrence of shading or the like.

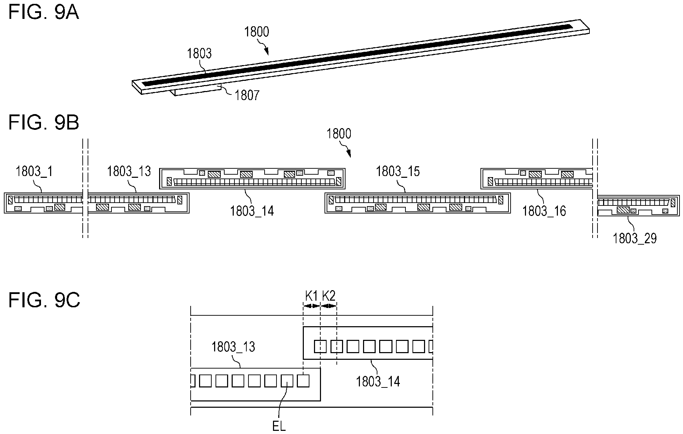

In the present embodiment, an example in which a light-emitting device is used for a head substrate 1800 of an exposure head of an image-forming apparatus is described below with reference to Fig. 9.

Fig. 9A is a schematic perspective view of a head substrate 1800. Fig. 9B illustrates an arrangement of a plurality of light-emitting elements EL provided on the head substrate 1800, and Fig. 9C is a partial enlarged view of Fig. 9B.

An LED chip 1803 is mounted on the head substrate 1800. The LED chip 1803 may be, for example, a light-emitting device illustrated in Fig. 8.

As illustrated in Fig. 9A, the LED chip 1803 is provided on one surface of the head substrate 1800, and a long flexible flat cable (FFC) connector 1807 is provided on the other surface. The one surface of the head substrate 1800 is a surface (upper surface or front surface) on which the LED chip 1803 is provided. The other surface of the head substrate 1800 is a surface (lower surface or back surface) opposite to the surface on which the LED chip 1803 is provided.

The FFC connector 1807 is attached to the other surface (lower surface or back surface) of the head substrate 1800 such that the longitudinal direction thereof is along the longitudinal direction of the head substrate 1800. The long FFC connector 1807 is provided for inputting a control signal (drive signal) from a control circuit portion of the main body of the image-forming apparatus, and the control signal is transferred to each LED chip 1803. The LED chip 1803 is driven (turned on and off) by a control signal input to the head substrate 1800.

The LED chip 1803 mounted on the head substrate 1800 is described below. As illustrated in Figs. 9B and 9C, a plurality of LED chips 1803 are arranged on one surface of the head substrate 1800. For example, LED chips 1803_1 to 1803_29 (29 chips) are arranged. Fig. 9B illustrates the LED chips 1803_1, 1803_13, 1803_14, 1803_15, 1803_16, and 1803_29. In each of the LED chips 1803_1 to 1803_29, a plurality of light-emitting elements EL are arranged in the longitudinal direction, and, for example, 516 light-emitting elements EL are arranged.

In the longitudinal direction of the LED chip 1803, the center-to-center distance k2 between adjacent light-emitting elements EL corresponds to the resolution of the image-forming apparatus. For example, when the resolution of the image-forming apparatus according to the present embodiment is 1200 dpi, the light-emitting elements EL are arranged in the longitudinal direction of the LED chips 1803_1 to 1803_29 such that the center-to-center distance k2 between adjacent light-emitting elements EL is 21.16 µm. Thus, the exposure range of the exposure head of the present embodiment is approximately 314 mm.

A photosensitive layer of a photosensitive drum is formed at a width of 314 mm or more. The length of the long side of an A4-size recording paper and the length of the short side of an A3-size recording paper are 297 mm. The exposure head of the present embodiment therefore has an exposure range capable of forming an image on an A4-size recording paper and an A3-size recording paper. Although Fig. 9B illustrates an example in which a plurality of light-emitting elements EL are arranged in the longitudinal direction, the light-emitting elements EL may be arranged in the transverse direction in addition to the longitudinal direction.

The LED chips 1803_1 to 1803_29 are arranged in the axial direction of the photosensitive drum. More specifically, the LED chips 1803_1 to 1803_29 are alternately arranged in two rows in the axial direction of the photosensitive drum. More specifically, as illustrated in Fig. 9B, the odd-numbered LED chips 1803_1, 1803_3, ..., and 1803_29 counted from the left side are mounted in a line in the longitudinal direction of the head substrate 1800. Furthermore, the even-numbered LED chips 1803_2, 1803_4, ..., and 1803_28 counted from the left side are mounted in a line in the longitudinal direction of the head substrate 1800. The LED chips 1803 are arranged in this manner.

Thus, as illustrated in Fig. 9C, the center-to-center distance k1 between the light-emitting elements EL and the center-to-center distance k2 between the light-emitting elements EL can be made equal in the longitudinal direction of the LED chip 1803. The center-to-center distance k1 between the light-emitting elements EL indicates the center-to-center distance between the light-emitting elements EL arranged at one end of the LED chip 1803_13 and at the other end of the LED chip 1803_14. The center-to-center distance k2 between the light-emitting elements EL indicates the center-to-center distance k2 between adjacent light-emitting elements EL in the LED chip 1803_14. Thus, the center-to-center distance k1 between adjacent light-emitting elements EL arranged at one end of one LED chip 1803 and at the other end of the other LED chip 1803 can be made equal to the center-to-center distance k2 between adjacent light-emitting elements EL on one LED chip 1803.

In the present embodiment, the light-emitting elements EL are organic light-emitting elements and are current-driven light-emitting elements. The organic light-emitting elements are arranged, for example, in a line in the main scanning direction (the axial direction of the photosensitive drum) on a thin film transistor (TFT) substrate and are electrically connected in parallel by power supply wiring provided in the main scanning direction.

When the light-emitting device is used in the exposure head, due to linear exposure, the ratio of the dimension in the longitudinal direction (a first direction X) to the dimension in the transverse direction (a second direction Y) of the light-emitting region 1702 is higher than when the light-emitting device is used in a display apparatus or the like. The ratio of the dimension in the longitudinal direction (the first direction X) to the dimension in the transverse direction (the second direction Y) of the substrate of the LED chip is also higher. More specifically, for example, the length of the long side of the LED chip 1803 (or the light-emitting region 1702) is five times or more, possibly ten times or more, the length of the short side of the LED chip 1803 (or the light-emitting region 1702). For example, the length of the long side of the LED chip 1803 (or the light-emitting region 1702) can be 20 times or more the length of the short side of the LED chip 1803 (or the light-emitting region 1702).

The length of the long side of the LED chip 1803 is determined by the length of the photosensitive drum in the axial direction, the number of LED chips arranged in the axial direction, and the arrangement of the LED chips 1803. The length of the short side of the LED chip 1803 is determined depending on whether the light-emitting elements EL are disposed in the light-emitting region 1702 or the arrangement of the pad 1704 and the contact region 1703 in the direction perpendicular to the axis of the photosensitive drum.

The organic compound layer of the light-emitting elements EL may include a light-emitting layer that emits red light in consideration of the wavelength dependence of the photosensitivity of the photosensitive drum.

The LED chip 1803 may have a color filter. The color filter can improve print quality because it can absorb stray light from an unintended direction without reducing the normal amount of light incident on the photosensitive drum.

### <<Constitutions Included>>

The disclosure of the present embodiment includes the following constitutions.

### (Constitution 1)

An organic light-emitting element including: an anode; a cathode; and an organic compound layer between the anode and the cathode,
wherein the organic compound layer includes a light-emitting layer and an adjacent layer in contact with a cathode side of the light-emitting layer,
the light-emitting layer contains a first organic compound and a light-emitting material,
the adjacent layer contains a second organic compound,
the first organic compound is a hydrocarbon compound with a hydrocarbon fused-ring skeleton,
the second organic compound is a hydrocarbon compound with a hydrocarbon fused-ring skeleton and at least one alkyl group,
a maximum number of fused rings in the hydrocarbon fused-ring skeleton of the second organic compound is smaller than a maximum number of fused rings in the hydrocarbon fused-ring skeleton of the first organic compound,
the light-emitting material is a hydrocarbon compound with a hydrocarbon fused-ring skeleton,
a maximum number of fused rings in the hydrocarbon fused-ring skeleton of the first organic compound is smaller than a maximum number of fused rings in the hydrocarbon fused-ring skeleton of the light-emitting material, and
a difference between the maximum number of fused rings in the hydrocarbon fused-ring skeleton of the first organic compound and the maximum number of fused rings in the hydrocarbon fused-ring skeleton of the light-emitting material is larger than a difference between the maximum number of fused rings in the hydrocarbon fused-ring skeleton of the first organic compound and the maximum number of fused rings in the hydrocarbon fused-ring skeleton of the second organic compound.

### (Constitution 2)

An organic light-emitting element including: an anode; a cathode; and an organic compound layer between the anode and the cathode,
wherein the organic compound layer includes a light-emitting layer and an adjacent layer in contact with a cathode side of the light-emitting layer,
the light-emitting layer contains a first organic compound and a light-emitting material,
the adjacent layer contains a second organic compound,
the first organic compound is a hydrocarbon compound with a hydrocarbon fused-ring skeleton,
the second organic compound is a hydrocarbon compound with a hydrocarbon fused-ring skeleton and at least one alkyl group, and
the hydrocarbon fused-ring skeleton with the maximum number of fused rings in the first organic compound is a perylene skeleton.

### (Constitution 3)

An organic light-emitting element including: an anode; a cathode; and an organic compound layer between the anode and the cathode,
wherein the organic compound layer includes a light-emitting layer and an adjacent layer in contact with a cathode side of the light-emitting layer,
the light-emitting layer contains a first organic compound and a light-emitting material,
the adjacent layer contains a second organic compound,
the first organic compound is a hydrocarbon compound with a hydrocarbon fused-ring skeleton,
the second organic compound is a hydrocarbon compound with a hydrocarbon fused-ring skeleton and at least one alkyl group, and
the light-emitting material is a red-light-emitting material.

### (Constitution 4)

The organic light-emitting element according to Constitution 2 or 3, wherein a maximum number of fused rings in the hydrocarbon fused-ring skeleton of the second organic compound is smaller than the maximum number of fused rings in the hydrocarbon fused-ring skeleton of the first organic compound.

### (Constitution 5)

The organic light-emitting element according to any one of Constitutions 1 to 3, wherein the first organic compound has at least one alkyl group.

### (Constitution 6)

The organic light-emitting element according to any one of Constitutions 2 to 5, wherein the light-emitting material is a hydrocarbon compound with a hydrocarbon fused-ring skeleton.

### (Constitution 7)

The organic light-emitting element according to any one of Constitutions 1 to 6, wherein the light-emitting material has at least one alkyl group.

### (Constitution 8)

The organic light-emitting element according to any one of Constitutions 2 to 7, wherein a difference between the maximum number of fused rings in the hydrocarbon fused-ring skeleton of the first organic compound and a maximum number of fused rings in the hydrocarbon fused-ring skeleton of the light-emitting material is larger than a difference between the maximum number of fused rings in the hydrocarbon fused-ring skeleton of the first organic compound and a maximum number of fused rings in the hydrocarbon fused-ring skeleton of the second organic compound.

### (Constitution 9)

The organic light-emitting element according to any one of Constitutions 1 and 3 to 8, wherein the hydrocarbon fused-ring skeleton with the maximum number of fused rings in the first organic compound has a perylene moiety.

### (Constitution 10)

The organic light-emitting element according to any one of Constitutions 1 and 3 to 9, wherein the hydrocarbon fused-ring skeleton with the maximum number of fused rings in the first organic compound is a perylene skeleton.

### (Constitution 11)

The organic light-emitting element according to any one of Constitutions 1 to 10, wherein a hydrocarbon fused-ring skeleton with a maximum number of fused rings in the light-emitting material has a perylene moiety.

### (Constitution 12)

The organic light-emitting element according to any one of Constitutions 1 to 11, wherein the hydrocarbon fused-ring skeleton with the maximum number of fused rings in the second organic compound has a pyrene moiety.

### (Constitution 13)

The organic light-emitting element according to Constitution 12, wherein the hydrocarbon fused-ring skeleton with the maximum number of fused rings in the second organic compound is a pyrene skeleton.

### (Constitution 14)

The organic light-emitting element according to any one of Constitutions 1 to 13, wherein the first organic compound and the second organic compound are different compounds.

### (Constitution 15)

The organic light-emitting element according to any one of Constitutions 1 to 14, wherein the organic light-emitting element emits red light.

### (Constitution 16)

The organic light-emitting element according to any one of Constitutions 1 to 14, wherein the organic light-emitting element emits white light.

### (Constitution 17)

A display apparatus including a plurality of pixels, wherein at least one of the plurality of pixels includes the organic light-emitting element according to any one of Constitutions 1 to 16 and a transistor coupled to the organic light-emitting element.

### (Constitution 18)

An image display apparatus including: an input portion configured to input image information; and a display unit configured to output an image,
wherein the display unit includes the display apparatus according to Constitution 17.

### (Constitution 19)

A photoelectric conversion apparatus including: an optical unit including a plurality of lenses; an imaging element configured to receive light passing through the optical unit; and a display unit configured to display an image taken by the imaging element,
wherein the display unit includes the organic light-emitting element according to any one of Constitutions 1 to 16.

### (Constitution 20)

Electronic equipment including: a display unit including the organic light-emitting element according to any one of Constitutions 1 to 16; a housing configured to be provided with the display unit; and a communication unit provided in the housing and configured to communicate with an outside.

### (Constitution 21)

A lighting apparatus including: a light source including the organic light-emitting element according to any one of Constitutions 1 to 16; and a light-diffusing unit or an optical filter configured to transmit light emitted by the light source.

### (Constitution 22)

A moving body including: a lamp including the organic light-emitting element according to any one of Constitutions 1 to 16; and a body configured to be provided with the lamp.

### (Constitution 23)

An exposure light source for an electrophotographic image-forming apparatus, including the organic light-emitting element according to any one of Constitutions 1 to 16.

### Exemplary Embodiments

### <Exemplary Embodiment 1>

A 40-nm titanium (Ti) film was formed on a silicon substrate as an anode by a sputtering method and was patterned by photolithography to form a regular hexagonal Ti pixel array and wiring such that the pixel pitch was 4.2 µm. Furthermore, a silicon nitride (SiN) insulating layer was formed on Ti and was patterned by photolithography such that the width of a pixel array in which Ti was exposed and the width of the SiN insulating layer partitioning the pixel array were 1 µm.

Subsequently, the substrate washed with water on which layers up to the insulating layer were formed and a material disposed in an evaporation boat made of molybdenum or tungsten were mounted in a vacuum evaporator, and were subjected to UV/ozone cleaning. After evacuation to 1.0 x 10⁻⁴ Pa (1 x 10⁻⁶ Torr), a film with a layer structure shown in Table 2 was formed. The substrate was then transferred to a glove box and was sealed with a glass cap containing a drying agent in a nitrogen atmosphere to produce an organic EL element.

**Table 2**

| | Material | | Thickness (nm) |
|---|---|---|---|
| Cathode | Mg:Ag (50:50) | | 15 |
| Electron injection layer (EIL) | LiF | | 1 |
| Electron transport layer (ETL) | ET2 | | 40 |
| Adjacent layer (HBL) | E6 (second organic compound) | | 25 |
| Light-emitting layer (EML) | First organic compound (host) | H8: 99.7 wt% | 20 |
| | Light-emitting material | RD21: 0.3 wt% | |
| Hole transport layer (HTL) | HT2 | | 40 |
| Hole injection layer (HIL) | HT16 | | 8 |

The organic EL element was coupled to a voltage application apparatus, and its characteristics were evaluated. The voltage-current characteristics were measured with a microammeter 4140B manufactured by Hewlett-Packard Co., and an emission spectrum and luminous brightness were obtained with SR-3 manufactured by Topcon Corporation.

The current efficiency was 10.3 cd/A and the voltage was 4.6 V, as determined from the current value at a luminance of 30,000 cd/m² and the luminous brightness. The organic EL element was good in terms of high current efficiency and low voltage. Furthermore, the voltage ratio of the present exemplary embodiment was 0.9 when the voltage of Comparative Example 2 was 1.0.

A continuous operation test was performed at a current density of 100 mA/cm² to measure the time when the luminance decay rate reached 5%. The present exemplary embodiment had a luminance decay rate ratio of 1.3 on the assumption that the time when the luminance decay rate of Comparative Example 2 reached 5% was 1.0.

### <Exemplary Embodiments 2 to 22 and Comparative Examples 1 to 3>

Organic light-emitting elements were produced in the same manner as in Exemplary Embodiment 1 except that the compounds shown in Table 3 were used. Characteristics of the elements were measured and evaluated in the same manner as in Exemplary Embodiment 1. Table 3 shows the measurement results.

Comparative Compounds 1 to 3 and Compounds 4 to 6 used in Exemplary Embodiments and Comparative Examples are described below. Compound 4 is an orange light-emitting material, and Compound 5 is a green light-emitting material. These were synthesized by a known synthesis method.

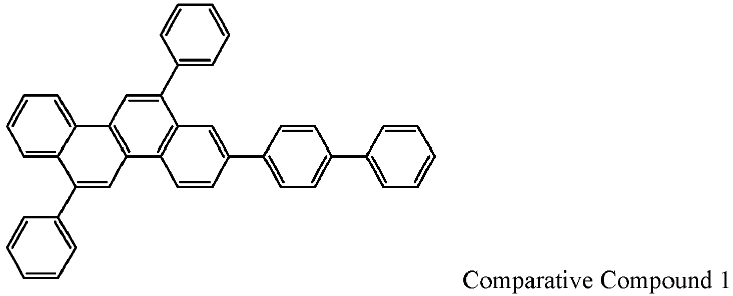

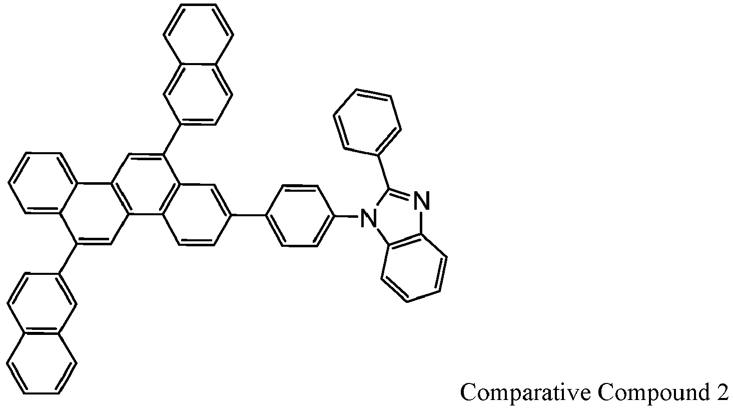

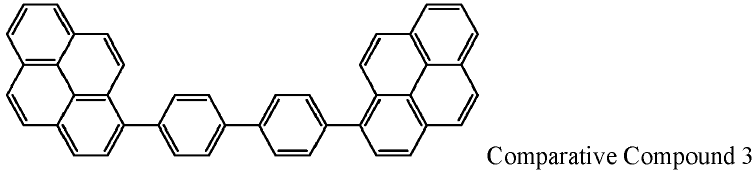

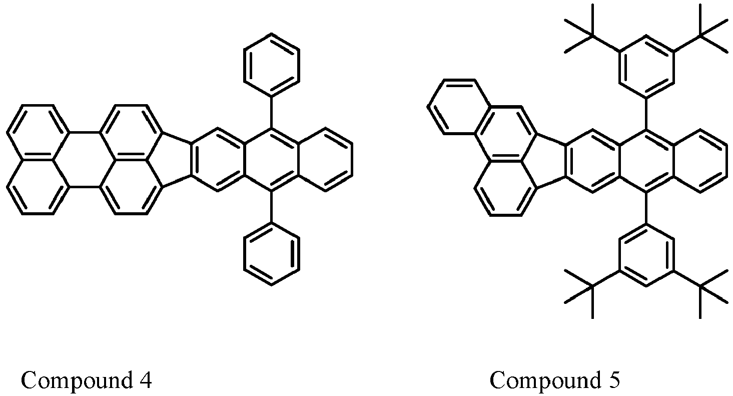

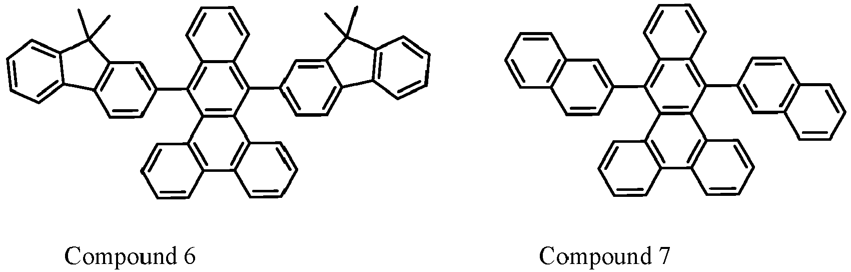

**Table 3**

| | HIL | HTL | Light-emitting layer | | HBL | ETL | Voltage ratio | Luminance decay rate ratio |
|---|---|---|---|---|---|---|---|---|
| | | | First organic compound | Light-emitting material | Second organic compound | | | |
| Exemplary embodiment 1 | HT16 | HT2 | H8 | RD21 | E6 | ET2 | 0.9 | 1.3 |
| Exemplary embodiment 2 | HT16 | HT2 | H8 | RD21 | E26 | ET2 | 1.0 | 1.3 |
| Comparative example 1 | HT16 | HT2 | H8 | RD21 | Comparative compound 2 | ET2 | 1.0 | 0.8 |
| Comparative example 2 | HT16 | HT2 | H8 | RD21 | Comparative compound 1 | ET2 | 1.0 | 1.0 |
| Comparative example 3 | HT16 | HT2 | H8 | RD21 | Comparative compound 3 | ET2 | 1.0 | 1.0 |
| Exemplary embodiment 3 | HT16 | HT2 | H8 | RD21 | H7 | ET2 | 1.0 | 1.2 |
| Exemplary embodiment 4 | HT16 | HT2 | H6 | RD21 | E6 | ET2 | 0.9 | 1.2 |
| Exemplary embodiment 5 | HT16 | HT2 | H3 | RD21 | E6 | ET2 | 0.9 | 1.4 |
| Exemplary embodiment 6 | HT16 | HT3 | H3 | RD20 | E6 | ET3 | 0.9 | 1.4 |
| Exemplary embodiment 7 | HT16 | HT3 | H9 | RD20 | E6 | ET3 | 0.9 | 1.4 |
| Exemplary embodiment 8 | HT16 | HT3 | H9 | RD22 | E6 | ET3 | 0.9 | 1.3 |
| Exemplary embodiment 9 | HT16 | HT3 | H9 | RD21 | E8 | ET3 | 0.9 | 1.4 |
| Exemplary embodiment 10 | HT16 | HT3 | H9 | RD21 | E5 | ET3 | 0.9 | 1.4 |
| Exemplary embodiment 11 | HT16 | HT3 | H9 | RD21 | E1 | ET3 | 0.9 | 1.4 |
| Exemplary embodiment 12 | HT16 | HT3 | H9 | RD21 | E17 | ET3 | 0.9 | 1.3 |
| Exemplary embodiment 13 | HT16 | HT3 | H9 | RD21 | E18 | ET3 | 0.9 | 1.3 |
| Exemplary embodiment 14 | HT16 | HT3 | H9 | RD21 | E18 | ET3 | 0.9 | 1.3 |
| Exemplary embodiment 15 | HT16 | HT2 | H1 | RD22 | E28 | ET3 | 1.0 | 1.2 |
| Exemplary embodiment 16 | HT16 | HT2 | H1 | RD22 | E24 | ET3 | 1.0 | 1.2 |
| Exemplary embodiment 17 | HT16 | HT2 | H1 | RD22 | E33 | ET3 | 1.0 | 1.2 |
| Exemplary embodiment 18 | HT16 | HT3 | H9 | RD20 | E48 | ET3 | 1.0 | 1.2 |
| Exemplary embodiment 19 | HT16 | HT3 | H13 | RD4 | E53 | ET3 | 1.0 | 1.1 |
| Exemplary embodiment 20 | HT16 | HT3 | H13 | RD10 | H3 | ET3 | 0.9 | 1.3 |
| Exemplary embodiment 21 | HT16 | HT2 | H19 | RD21 | E6 | ET2 | 0.9 | 1.3 |
| Exemplary embodiment 22 | HT16 | HT2 | H16 | RD21 | E6 | ET2 | 0.9 | 1.3 |
| Comparative example 4 | HT16 | HT3 | H13 | Compound 4 | H3 | ET3 | 0.9 | 0.6 |
| Comparative example 5 | HT16 | HT2 | H16 | Compound 5 | E6 | ET2 | 0.9 | 0.5 |
| Exemplary embodiment 23 | HT16 | HT2 | H23 | RD21 | E6 | ET2 | 1.0 | 1.1 |
| Exemplary embodiment 24 | HT16 | HT2 | Compound 6 | RD21 | E6 | ET2 | 0.9 | 1.2 |
| Exemplary embodiment 25 | HT16 | HT2 | Compound 7 | RD21 | E6 | ET2 | 1.0 | 1.1 |

### <Effects of Second Organic Compound with Hydrocarbon Fused-Ring Skeleton and Alkyl Group>

In Comparative Examples 1 to 3, the operational durability is higher in Comparative Examples 2 and 3 in which the second organic compound has a hydrocarbon fused-ring skeleton than Comparative Example 1 in which the second organic compound has a heteroatom. This is because a change to a hydrocarbon skeleton with low reactivity can suppress a side reaction from an excited state and degradation.

Furthermore, from Comparative Example 2 and Exemplary Embodiment 2, the second organic compound with a hydrocarbon fused-ring skeleton and an alkyl group improves the operational durability. This is because the compatibility at the interface between the light-emitting layer and an adjacent layer is increased, charge accumulation is reduced, and degradation can be suppressed.

Furthermore, in Exemplary Embodiment 1 and Exemplary Embodiment 2, Exemplary Embodiment 1 in which the second organic compound has a pyrene skeleton has a lower voltage. This is because the pyrene skeleton with high symmetry and planarity has a larger effect of improving compatibility at the interface due to substitution with an alkyl group.

### <Effects of Smaller Maximum Number of Fused Rings in Second Organic Compound than in First Organic Compound>

In Exemplary Embodiment 3 and Exemplary Embodiments 1 and 2, Exemplary Embodiments 1 and 2 in which the maximum number of fused rings is smaller in the second organic compound than in the first organic compound have higher operational durability than Exemplary Embodiment 3 in which the maximum number of fused rings in the first organic compound is the same as that in the second organic compound. This is because, in Exemplary Embodiments 1 and 2 in which the band gap of an adjacent layer is larger than that in Exemplary Embodiment 3, a side reaction caused by leakage of an exciton from the light-emitting layer to the adjacent layer and quenching of the exciton is less likely to occur, and degradation is suppressed.

### <Effects of First Organic Compound with Alkyl Group>

Exemplary Embodiments in which the first organic compound had an alkyl group had a larger effect of improving operational durability than Exemplary Embodiments 4 and 15 to 17 in which the first organic compound did not have an alkyl group. This is because the first organic compound and the second organic compound both having an alkyl group further increase the compatibility at the interface between the light-emitting layer and an adjacent layer, reduce charge accumulation, and enhance the effect of suppressing degradation.

### <Effects of Difference in Maximum Number of Fused Rings between First Organic Compound and Light-Emitting Material Being Greater than Difference in Maximum Number of Fused Rings between First Organic Compound and Second Organic Compound>

In Exemplary Embodiments 19 and 20, the first organic compound was the same. In Exemplary Embodiment 19, however, the difference in maximum number of fused rings between the first organic compound and the light-emitting material is smaller than the difference in maximum number of fused rings between the first organic compound and the second organic compound. On the other hand, in Exemplary Embodiment 20, the difference in maximum number of fused rings between the first organic compound and the light-emitting material is greater than the difference in maximum number of fused rings between the first organic compound and the second organic compound. When Exemplary Embodiments 19 and 20 are compared, Exemplary Embodiment 20 has improved operational durability and a lower voltage. This is because, in Exemplary Embodiment 20, the maximum numbers of fused rings of the light-emitting layer (the first organic compound) and an adjacent layer (the second organic compound) are closer to each other, and the effect of improving compatibility is therefore increased.

As described above, the present disclosure can provide an element with high durability at low voltage.

The present disclosure can provide an organic light-emitting element that achieves both low-voltage driving and high operational durability.

While the present disclosure has been described with reference to exemplary embodiments, it is to be understood that the disclosure is not limited to the disclosed exemplary embodiments. The scope of the following claims is to be accorded the broadest interpretation so as to encompass all such modifications and equivalent structures and functions.
An organic light-emitting element including: an anode (21); a cathode (23); and an organic compound layer (4, 22) between the anode and the cathode, wherein the organic compound layer includes a light-emitting layer and an adjacent layer (44) in contact with a cathode side of the light-emitting layer, the light-emitting layer contains a first organic compound and a light-emitting material, the adjacent layer contains a second organic compound, the first organic compound is a hydrocarbon compound with a hydrocarbon fused-ring skeleton, and the second organic compound is a hydrocarbon compound with a hydrocarbon fused-ring skeleton and at least one alkyl group.

The original claims of the priority application are repeated below in the present specification in the form of items and form part of the content of this European application.

Item 1. An organic light-emitting element comprising:
an anode (21);
a cathode (23); and
an organic compound layer (4, 22) between the anode and the cathode,
wherein the organic compound layer includes a light-emitting layer and an adjacent layer (44) in contact with a cathode side of the light-emitting layer,
the light-emitting layer contains a first organic compound and a light-emitting material,
the adjacent layer contains a second organic compound,
the first organic compound is a hydrocarbon compound with a hydrocarbon fused-ring skeleton,
the second organic compound is a hydrocarbon compound with a hydrocarbon fused-ring skeleton and at least one alkyl group,
a maximum number of fused rings in the hydrocarbon fused-ring skeleton of the second organic compound is smaller than a maximum number of fused rings in the hydrocarbon fused-ring skeleton of the first organic compound,
the light-emitting material is a hydrocarbon compound with a hydrocarbon fused-ring skeleton,
a maximum number of fused rings in the hydrocarbon fused-ring skeleton of the first organic compound is smaller than a maximum number of fused rings in the hydrocarbon fused-ring skeleton of the light-emitting material, and
a difference between the maximum number of fused rings in the hydrocarbon fused-ring skeleton of the first organic compound and the maximum number of fused rings in the hydrocarbon fused-ring skeleton of the light-emitting material is larger than a difference between the maximum number of fused rings in the hydrocarbon fused-ring skeleton of the first organic compound and the maximum number of fused rings in the hydrocarbon fused-ring skeleton of the second organic compound.

Item 2. An organic light-emitting element comprising:
an anode (21);
a cathode (23); and
an organic compound layer (4, 22) between the anode and the cathode,
wherein the organic compound layer includes a light-emitting layer and an adjacent layer (44) in contact with a cathode side of the light-emitting layer,
the light-emitting layer contains a first organic compound and a light-emitting material,
the adjacent layer contains a second organic compound,
the first organic compound is a hydrocarbon compound with a hydrocarbon fused-ring skeleton,
the second organic compound is a hydrocarbon compound with a hydrocarbon fused-ring skeleton and at least one alkyl group, and
the hydrocarbon fused-ring skeleton with the maximum number of fused rings in the first organic compound is a perylene skeleton.

Item 3. An organic light-emitting element comprising:
an anode (21);
a cathode (23); and
an organic compound layer (4, 22) between the anode and the cathode,
wherein the organic compound layer includes a light-emitting layer and an adjacent layer (44) in contact with a cathode side of the light-emitting layer,
the light-emitting layer contains a first organic compound and a light-emitting material,
the adjacent layer contains a second organic compound,
the first organic compound is a hydrocarbon compound with a hydrocarbon fused-ring skeleton,
the second organic compound is a hydrocarbon compound with a hydrocarbon fused-ring skeleton and at least one alkyl group, and
the light-emitting material is a red-light-emitting material.

Item 4. The organic light-emitting element according to Item 2 or 3, wherein a maximum number of fused rings in the hydrocarbon fused-ring skeleton of the second organic compound is smaller than the maximum number of fused rings in the hydrocarbon fused-ring skeleton of the first organic compound.

Item 5. The organic light-emitting element according to any one of Items 1 to 3, wherein the first organic compound has at least one alkyl group.

Item 6. The organic light-emitting element according to any one of Items 2 to 5, wherein the light-emitting material is a hydrocarbon compound with a hydrocarbon fused-ring skeleton.

Item 7. The organic light-emitting element according to any one of Items 1 to 6, wherein the light-emitting material has at least one alkyl group.

Item 8. The organic light-emitting element according to any one of Items 2 to 7, wherein a difference between the maximum number of fused rings in the hydrocarbon fused-ring skeleton of the first organic compound and a maximum number of fused rings in the hydrocarbon fused-ring skeleton of the light-emitting material is larger than a difference between the maximum number of fused rings in the hydrocarbon fused-ring skeleton of the first organic compound and a maximum number of fused rings in the hydrocarbon fused-ring skeleton of the second organic compound.

Item 9. The organic light-emitting element according to any one of Items 1 and 3 to 8, wherein the hydrocarbon fused-ring skeleton with the maximum number of fused rings in the first organic compound has a perylene moiety.

Item 10. The organic light-emitting element according to any one of Items 1 to 9, wherein the hydrocarbon fused-ring skeleton with the maximum number of fused rings in the first organic compound is a perylene skeleton.

Item 11. The organic light-emitting element according to any one of Items 1 to 10, wherein a hydrocarbon fused-ring skeleton with a maximum number of fused rings in the light-emitting material has a perylene moiety.

Item 12. The organic light-emitting element according to any one of Items 1 to 11, wherein the hydrocarbon fused-ring skeleton with the maximum number of fused rings in the second organic compound has a pyrene moiety.

Item 13. The organic light-emitting element according to Item 12, wherein the hydrocarbon fused-ring skeleton with the maximum number of fused rings in the second organic compound is a pyrene skeleton.

Item 14. The organic light-emitting element according to any one of Items 1 to 13, wherein the first organic compound and the second organic compound are different compounds.

Item 15. The organic light-emitting element according to any one of Items 1 to 14, wherein the organic light-emitting element emits red light.

Item 16. The organic light-emitting element according to any one of Items 1 to 14, wherein the organic light-emitting element emits white light.

Item 17. A display apparatus comprising a plurality of pixels, wherein at least one of the plurality of pixels includes the organic light-emitting element according to any one of Items 1 to 16 and a transistor coupled to the organic light-emitting element.

Item 18. An image display apparatus comprising:
an input portion configured to input image information; and
a display unit configured to output an image,
wherein the display unit includes the display apparatus according to Item 17.

Item 19. A photoelectric conversion apparatus comprising:
an optical unit including a plurality of lenses;
an imaging element configured to receive light passing through the optical unit; and
a display unit configured to display an image taken by the imaging element,
wherein the display unit includes the organic light-emitting element according to any one of Items 1 to 16.

Item 20. Electronic equipment comprising:
a display unit (1201) including the organic light-emitting element according to any one of Items 1 to 16;
a housing (1203) configured to be provided with the display unit; and
a communication unit provided in the housing and configured to communicate with an outside.

Item 21. Alighting apparatus comprising:
a light source (1402) including the organic light-emitting element according to any one of Items 1 to 16; and
a light-diffusing unit (1405) or an optical filter configured to transmit light emitted by the light source.

Item 22. A moving body comprising:
a lamp including the organic light-emitting element according to any one of Items 1 to 16; and
a body configured to be provided with the lamp.

Item 23. An image-forming apparatus comprising:
a photosensitive member (27); and
an exposure light source (28) configured to expose the photosensitive member,
wherein the exposure light source includes the organic light-emitting element according to any one of Items 1 to 16.

## Claims

1. An organic light-emitting element comprising:
an anode (21);
a cathode (23); and
an organic compound layer (4, 22) between the anode and the cathode,
wherein the organic compound layer includes a light-emitting layer and an adjacent layer (44) in contact with a cathode side of the light-emitting layer,
the light-emitting layer contains a first organic compound and a light-emitting material,
the adjacent layer contains a second organic compound,
the first organic compound is a hydrocarbon compound with a hydrocarbon fused-ring skeleton,
the second organic compound is a hydrocarbon compound with a hydrocarbon fused-ring skeleton and at least one alkyl group;
wherein (i)
a maximum number of fused rings in the hydrocarbon fused-ring skeleton of the second organic compound is smaller than a maximum number of fused rings in the hydrocarbon fused-ring skeleton of the first organic compound,
the light-emitting material is a hydrocarbon compound with a hydrocarbon fused-ring skeleton,
a maximum number of fused rings in the hydrocarbon fused-ring skeleton of the first organic compound is smaller than a maximum number of fused rings in the hydrocarbon fused-ring skeleton of the light-emitting material, and
a difference between the maximum number of fused rings in the hydrocarbon fused-ring skeleton of the first organic compound and the maximum number of fused rings in the hydrocarbon fused-ring skeleton of the light-emitting material is larger than a difference between the maximum number of fused rings in the hydrocarbon fused-ring skeleton of the first organic compound and the maximum number of fused rings in the hydrocarbon fused-ring skeleton of the second organic compound;
or wherein (ii)
the hydrocarbon fused-ring skeleton with the maximum number of fused rings in the first organic compound is a perylene skeleton;
or wherein (iii)
the light-emitting material is a red-light-emitting material.

2. The organic light-emitting element according to alternative (ii) or (iii) of claim 1, wherein a maximum number of fused rings in the hydrocarbon fused-ring skeleton of the second organic compound is smaller than the maximum number of fused rings in the hydrocarbon fused-ring skeleton of the first organic compound.

3. The organic light-emitting element according to claim 1 , wherein the first organic compound has at least one alkyl group.

4. The organic light-emitting element according to any one of alternatives (ii) or (iii) of claim 1, or claims 2 or 3, wherein the light-emitting material is a hydrocarbon compound with a hydrocarbon fused-ring skeleton.

5. The organic light-emitting element according to any one of claims 1 to 4,
wherein the light-emitting material has at least one alkyl group.

6. The organic light-emitting element according to any one of alternatives (ii) or (iii) of claim 1, or claims 2 to 5, wherein a difference between the maximum number of fused rings in the hydrocarbon fused-ring skeleton of the first organic compound and a maximum number of fused rings in the hydrocarbon fused-ring skeleton of the light-emitting material is larger than a difference between the maximum number of fused rings in the hydrocarbon fused-ring skeleton of the first organic compound and a maximum number of fused rings in the hydrocarbon fused-ring skeleton of the second organic compound.

7. The organic light-emitting element according to any one of claims 1 to 6, wherein the hydrocarbon fused-ring skeleton with the maximum number of fused rings (iv) in the first organic compound has a perylene moiety, preferably is a perylene skeleton; or
(v) in the light-emitting material has a perylene moiety; or
(vi) in the second organic compound has a pyrene moiety, preferably in the second organic compound is a pyrene skeleton.

8. The organic light-emitting element according to any one of claims 1 to 7,
wherein the first organic compound and the second organic compound are different compounds; or
wherein the organic light-emitting element emits red light or white light.

9. A display apparatus comprising a plurality of pixels, wherein at least one of the plurality of pixels includes the organic light-emitting element according to any one of claims 1 to 8 and a transistor coupled to the organic light-emitting element.

10. An image display apparatus comprising:
an input portion configured to input image information; and
a display unit configured to output an image,
wherein the display unit includes the display apparatus according to claim 9.

11. A photoelectric conversion apparatus comprising:
an optical unit including a plurality of lenses;
an imaging element configured to receive light passing through the optical unit; and
a display unit configured to display an image taken by the imaging element,
wherein the display unit includes the organic light-emitting element according to any one of claims 1 to 8.

12. Electronic equipment comprising:
a display unit (1201) including the organic light-emitting element according to any one of claims 1 to 8;
a housing (1203) configured to be provided with the display unit; and
a communication unit provided in the housing and configured to communicate with an outside.

13. A lighting apparatus comprising:
a light source (1402) including the organic light-emitting element according to any one of claims 1 to 8; and
a light-diffusing unit (1405) or an optical filter configured to transmit light emitted by the light source.

14. A moving body comprising:
a lamp including the organic light-emitting element according to any one of claims 1 to 8; and
a body configured to be provided with the lamp.

15. An image-forming apparatus comprising:
a photosensitive member (27); and
an exposure light source (28) configured to expose the photosensitive member,
wherein the exposure light source includes the organic light-emitting element according to any one of claims 1 to 8.
